# EUROPEAN PATENT APPLICATION

(11) **EP 4 822 682 A1**
(43) Date of publication of application: **14.10.2026**
(21) Application number: 24931871.8
(22) Date of filing: 29.03.2024
(51) Int. Cl.: G09G 3/32, H10K 50/86

(54) **DISPLAY PANEL, DISPLAY APPARATUS AND DRIVING METHOD**

(71) Applicant: Boe Technology Group Co., Ltd., Beijing 100015 (CN)
(72) Inventor: HSIEH, Mingche, Beijing 100176 (CN); HAN, Xinbin, Beijing 100176 (CN); ZHANG, Hao, Beijing 100176 (CN)
(74) Representative: Cohausz & Florack
(86) International application number: PCT/CN2024/084976
(87) International publication number: WO 2025/199996

(57) **Abstract**

Disclosed are a display panel, a display apparatus and a driving method. The display panel comprises: a substrate, having a first display area (AA1) and a second display area (AA2); a plurality of first sub-pixels (P1) located in the first display area (AA1); and a plurality of second sub-pixels (P2) located in the second display area (AA2). At least one second sub-pixel (P2) of the plurality of second sub-pixels (P2) comprises a first pixel portion (P21) and a second pixel portion (P22), the light-emitting area of the first pixel portion (P21) being less than the light-emitting area of the second pixel portion (P22).

## Description

### Technical Field

The present disclosure relates to the field of the semiconductor technology, and in particular to a display panel, a display apparatus and a driving method.

### Background

With the continuous development of the display technology, people's needs for display methods are becoming more and more diversified. In some display applications, users like to share information with others. In other application scenarios, users need to protect their privacy and need display products with an anti-peep function, for example, a scenario where a user inputs personal data in his cell phone, a scenario where a user handles confidential company information, and so on. Therefore, display sharing and privacy switching are gradually becoming a functional trend of display products.

### Summary

Embodiments of the present disclosure provide a display panel, a display apparatus and a driving method. The display panel includes: a substrate, having a first display region and a second display region; a plurality of first sub-pixels in the first display region; and a plurality of second sub-pixels in the second display region; wherein at least one of the plurality of second sub-pixels includes: a first pixel portion and a second pixel portion; wherein a light-emitting area of the first pixel portion is smaller than a light-emitting area of the second pixel portion.

In a possible implementation mode, at least one of the plurality of first sub-pixels includes: a third pixel portion and a fourth pixel portion; and a light-emitting area of the third pixel portion is equal to a light-emitting area of the fourth pixel portion.

In a possible implementation mode, at least one of the plurality of first sub-pixels includes: a third pixel portion and a fourth pixel portion; and a light-emitting area of the third pixel portion is smaller than a light-emitting area of the fourth pixel portion.

In a possible implementation mode, the light-emitting area of the fourth pixel portion is equal to the light-emitting area of the second pixel portion.

In a possible implementation mode, at least one of the plurality of first sub-pixels is of an one-piece connection structure.

In a possible implementation mode, a light-emitting area of the first sub-pixel is greater than or equal to a sum of the light-emitting area of the first sub-pixel portion and the light-emitting area of the second pixel portion.

In a possible implementation mode, the display panel includes: a first shielding layer; the first shielding layer includes: a first opening and a second opening; an orthographic projection of the first opening on the substrate has an overlapping region with an orthographic projection of the first pixel portion on the substrate; an orthographic projection of the second opening on the substrate has an overlapping region with an orthographic projection of the second pixel portion on the substrate; and an area of the orthographic projection of the first opening on the substrate is less than an area of the orthographic projection of the second opening on the substrate.

In a possible implementation mode, at least one of the plurality of first sub-pixels includes: a third pixel portion and a fourth pixel portion; the first shielding layer further includes: a third opening and a fourth opening; an orthographic projection of the third opening on the substrate has an overlapping region with an orthographic projection of the third pixel portion on the substrate; an orthographic projection of the fourth opening on the substrate has an overlapping region with an orthographic projection of the fourth pixel portion on the substrate; and an area of the orthographic projection of the fourth opening on the substrate is equal to the area of the orthographic projection of the second opening on the substrate.

In a possible implementation mode, an area of the orthographic projection of the third opening on the substrate is equal to the area of the orthographic projection of the fourth opening on the substrate.

In a possible implementation mode, an area of the orthographic projection of the third opening on the substrate is less than the area of the orthographic projection of the fourth opening on the substrate.

In a possible implementation mode, at least one of the plurality of first sub-pixels is of an one-piece connection structure; the first shielding layer further includes: a fifth opening; and an orthographic projection of the fifth opening on the substrate has an overlapping region with an orthographic projection of the first sub-pixel on the substrate.

In a possible implementation mode, an area of the orthographic projection of the fifth opening on the substrate is greater than or equal to a sum of the area of the orthographic projection of the first opening on the substrate and the area of the orthographic projection of the second opening on the substrate.

In a possible implementation mode, the first opening includes: a plurality of first sub-openings; and the plurality of first sub-openings of the first opening are distributed in an array.

In a possible implementation mode, an orthographic projection of the first sub-opening on the substrate has a rectangular, hexagonal, octagonal, circular, or elliptical pattern.

In a possible implementation mode, the first pixel portion includes: a first anode portion; and the second pixel portion includes: a second anode portion. An area of an orthographic projection of the first anode portion on the substrate is smaller than an area of an orthographic projection of the second anode portion on the substrate.

In a possible implementation mode, at least one of the plurality of first sub-pixels includes: a third pixel portion and a fourth pixel portion; the third pixel portion includes a third anode portion, and the fourth pixel portion includes a fourth anode portion; and an area of an orthographic projection of the third anode portion on the substrate is equal to an area of an orthographic projection of the fourth anode portion on the substrate, and both are equal to an area of an orthographic projection of the second anode portion on the substrate.

In a possible implementation mode, at least one of the plurality of first sub-pixels is of an one-piece connection structure; the first sub-pixel portion includes: a fifth anode portion; and an area of an orthographic projection of the fifth anode portion on the substrate is greater than or equal to a sum of the area of the orthographic projection of the first anode portion on the substrate and the area of the orthographic projection of the second anode portion on the substrate.

In a possible implementation mode, the display panel further includes: a second light-shielding layer on a side of the first light-shielding layer facing the substrate; the second light-shielding layer includes: a first light outlet and a second light outlet; an orthographic projection of the first light outlet on the substrate has an overlapping region with the orthographic projection of the first opening on the substrate; and an orthographic projection of the second light outlet on the substrate has an overlapping region with the orthographic projection of the second opening on the substrate.

In a possible implementation mode, the display panel further includes: a lens layer on a side of the first light-shielding layer facing away from the substrate; the lens layer includes: a first lens and a second lens; an orthographic projection of the first lens on the substrate covers the orthographic projection of the first opening on the substrate; and an orthographic projection of the second lens on the substrate covers the orthographic projection of the second opening on the substrate.

In a possible implementation mode, the display panel further includes: an encapsulation layer, and a touch layer on a side of the encapsulation layer facing away from the substrate; and the first light-shielding layer is disposed on a side of the encapsulation layer facing away from the substrate.

In a possible implementation mode, at least the second sub-pixels among the first sub-pixels and the second sub-pixels include: a plurality of light emitters disposed in a stacked manner along a direction perpendicular to the substrate. The light emitters include one or a combination of following film layers disposed in a stacked manner: a hole transport layer; a light-emitting layer; or an electron transport layer.

In a possible implementation mode, the second sub-pixel includes: a second pixel circuit; and the first anode portion and the second anode portion are both electrically connected to the second pixel circuit.

In a possible implementation mode, the second pixel circuit includes at least a first light-emitting control sub-circuit and a second light-emitting control sub-circuit; the display panel further includes: a first light-emitting control line and a second light-emitting control line; the first light-emitting control sub-circuit is electrically connected to the first light-emitting control line and the first anode portion, and is configured to drive the first pixel portion to emit light under control of the first light-emitting control line; and the second light-emitting control sub-circuit is electrically connected to the second light-emitting control line and the second anode portion, and is configured to drive the second pixel portion to emit light under control of the second light-emitting control line.

In a possible implementation mode, the second sub-pixel includes: a first sub-pixel circuit and a second sub-pixel circuit; the first anode portion is electrically connected to the first sub-pixel circuit; and the second anode portion is electrically connected to the second sub-pixel circuit.

In a possible implementation mode, the plurality of second sub-pixels include: first pixel rows and second pixel rows; the first pixel rows and the second pixel rows extend in a first direction and are alternately arranged in a second direction; the first pixel row includes: a plurality of first pixel portions; and the second pixel row includes: a plurality of second pixel portions. The display panel further includes: a first pixel row control line and a second pixel row control line; the first pixel row control line is electrically connected to the first pixel portions of the first pixel row, and the second pixel row control line is electrically connected to the second pixel portions of the second pixel row; and the first pixel row control line is configured to provide a signal to the first pixel portions of the first pixel row, and the second pixel row control line is configured to provide a signal to the second pixel portions of the second pixel row.

The embodiments of the present disclosure provide a display apparatus, including the display panel according to the embodiments of the present disclosure.

The embodiments of the present disclosure further provide a driving method for the display panel according to the embodiments of the present disclosure, including: in response to a normal display mode, controlling at least a portion of the plurality of first sub-pixels in the first display region and at least the second pixel portion in the second display region to emit light; and in response to a localized anti-peek display mode, controlling at least a portion of the plurality of first sub-pixels in the first display region and the first sub-pixel portion in the second display region to emit light.

In a possible implementation mode, in response to the normal display mode, controlling at least a portion of the plurality of first sub-pixels in the first display region and at least the second pixel portion in the second display region to emit light, includes: in response to the normal display mode, controlling the fourth pixel portion in the first display region and the second pixel portion in the second display region to emit light. In response to the localized anti-peek display mode, controlling at least a portion of the plurality of first sub-pixels in the first display region and the first sub-pixel portion in the second display region to emit light, includes: controlling the third pixel portion in the first display region and the first sub-pixel portion in the second display region to emit light.

In a possible implementation mode, in response to the normal display mode, controlling at least a portion of the plurality of first sub-pixels in the first display region and at least the second pixel portion in the second display region to emit light, includes: in response to the normal display mode, controlling all of the plurality of first sub-pixels in the first display region and all of the plurality of second sub-pixels in the second display region to emit light. In response to the localized anti-peek display mode, controlling at least a portion of the plurality of first sub-pixels in the first display region and the first sub-pixel portion in the second display region to emit light, includes: controlling all of the plurality of first sub-pixels in the first display region and the first sub-pixel portion in the second display region to emit light.

In a possible implementation mode, in response to the normal display mode, controlling at least a portion of the plurality of first sub-pixels in the first display region and at least the second pixel portion in the second display region to emit light, includes: in response to the normal display mode, controlling all of the plurality of first sub-pixels in the first display region and the second pixel portion in the second display region to emit light. In response to the localized anti-peek display mode, controlling at least a portion of the plurality of first sub-pixels in the first display region and the first sub-pixel portion in the second display region to emit light, includes: controlling all of the plurality of first sub-pixels in the first display region and the first pixel portion in the second display region to emit light.

In a possible implementation mode, the driving method further includes: in response to the normal display mode, based on a difference in brightness between the first display region and the second display region, calling a stored relationship table, and adjusting the brightness of the first display region and the second display region.

### Brief Description of Figures

FIG. 1A is a first schematic diagram of a display panel according to embodiments of the present disclosure.
FIG. 1B is a schematic diagram of FIG. 1A in a case of an anti-peep display mode.
FIG. 1C is a schematic diagram of FIG. 1A in a case of a normal display mode.
FIG. 1D is a schematic diagram of dividing an anode into a first anode portion and a second anode portion according to embodiments of the present disclosure.
FIG. 2A is a schematic diagram of a cross-section of FIG. 1A at a position of a dashed line A1A2.
FIG. 2B is a schematic diagram of a cross-section of FIG. 1A at a position of a dashed line A3A4.
FIG. 2C is another schematic diagram of a cross-section of FIG. 1A at a position of a dashed line A1A2.
FIG. 2D is a schematic diagram of a first opening of FIG. 2C at a first pixel portion P21.
FIG. 3 is a pixel circuit diagram of a second display region corresponding to FIG. 1A.
FIG. 4A is a schematic diagram of the wiring connection of a second display region corresponding to FIG. 1A.
FIG. 4B is a schematic diagram of the wiring connection of a first display region corresponding to FIG. 1A.
FIG. 5A is a second schematic diagram of a display panel according to embodiments of the present disclosure.
FIG. 5B is a schematic diagram of FIG. 5A in a case of an anti-peep display mode.
FIG. 5C is a schematic diagram of FIG. 5A in a case of a normal display mode.
FIG. 6A is a schematic diagram of a cross-section of FIG. 5A at a position of a dashed line A1A2.
FIG. 6B is a schematic diagram of a cross-section of FIG. 5A at a position of a dashed line A3A4.
FIG. 7 is a pixel circuit diagram of a second display region corresponding to FIG. 5A.
FIG. 8 is a schematic diagram of the wiring connection of a first display region and a second display region corresponding to FIG. 5A.
FIG. 9A is a third schematic diagram of a display panel according to embodiments of the present disclosure.
FIG. 9B is a schematic diagram of FIG. 9A in a case of an anti-peep display mode.
FIG. 9C is a schematic diagram of FIG. 9A in a case of a normal display mode.
FIG. 10A is a schematic diagram of a cross-section of FIG. 9A at a position of a dashed line A1A2.
FIG. 10B is a schematic diagram of a cross-section of FIG. 9A at a position of a dashed line A3A4.
FIG. 11 is a pixel circuit diagram of a second display region corresponding to FIG. 9A.
FIG. 12A is a fourth schematic diagram of a display panel according to embodiments of the present disclosure.
FIG. 12B is a fifth schematic diagram of a display panel according to embodiments of the present disclosure.
FIG. 13A is a sixth schematic diagram of a display panel according to embodiments of the present disclosure.
FIG. 13B is a seventh schematic diagram of a display panel according to embodiments of the present disclosure.
FIG. 14 is a schematic diagram of the stacking of a first pixel portion according to embodiments of the present disclosure.
FIG. 15 is a schematic diagram of having a plurality of first display regions and a second display region according to embodiments of the present disclosure.
FIG. 16 is a schematic diagram of an application scenario of a display panel according to embodiments of the present disclosure.
FIG. 17 is a schematic diagram of a structure of a display panel according to embodiments of the present disclosure.
FIG. 18 is a schematic flowchart of a driving method of a display panel according to embodiments of the present disclosure.

### Detailed Description

In order to make the purpose, technical solutions and advantages of embodiments of the present disclosure clearer, the technical solutions of embodiments of the present disclosure will be described clearly and completely in the following in conjunction with accompanying drawings of embodiments of the present disclosure. Obviously, the described embodiments are a part of the embodiments of the present disclosure, and not all of the embodiments. Based on the described embodiments of the present disclosure, all other embodiments obtained by a person of ordinary skill in the art without the creative labor are within the scope of protection of the present disclosure.

Unless otherwise defined, technical or scientific terms used in the present disclosure shall have the ordinary meaning understood by a person of ordinary skill in the field to which the present disclosure belongs. The words "first", "second" and the like used in the present disclosure do not indicate any order, number, or significance, but are only used to distinguish different components. The words "including" or "comprising" and the like are intended to mean that the element or object preceded by the word encompasses the elements or objects listed after the word and their equivalents, without excluding other elements or objects. The words such as "connected" or "linked" are not limited to physical or mechanical connections, but may include electrical connections, whether direct or indirect. The words "above", "below", "left", "right", and the like are used only to indicate relative positional relationships. When the absolute position of the described object is changed, the relative positional relationship may also be changed accordingly.

As used herein, "about" or "approximately the same" includes the stated value and means an acceptable range of deviation from the specific value determined by a person of ordinary skill in the art taking into account the measurement discussed and errors (i.e., the limitation of the measurement system) associated with the measurement of the specific value. For example, "substantially the same" may mean that the difference relative to the stated value is within one or more standard deviations, or within ±30 %, 20 %, 10 % or 5 %.

In the accompanying drawings, thicknesses of layers, films, panels, regions and the like are enlarged for clarity. Exemplary embodiments are described herein with reference to a cross-sectional view as a schematic diagram of an idealized embodiment. In this way, deviations from the shape of the drawing as a result of, for example manufacturing techniques and/or tolerances, will be expected. Thus, the embodiments described herein should not be construed as being limited to the specific shape of a region as shown herein, but include deviations in shape caused by, for example, manufacturing. For example, a region illustrated or described as flat may typically have rough and/or non-linear features. Furthermore, sharp corners illustrated may be rounded. Thus, regions shown in the drawings are schematic in nature and their shapes are not intended to illustrate precise shapes of the regions and are not intended to limit the scope of the present claims.

In order to keep the following description of embodiments of the present disclosure clear and concise, the present disclosure omits detailed descriptions of known functions and known components.

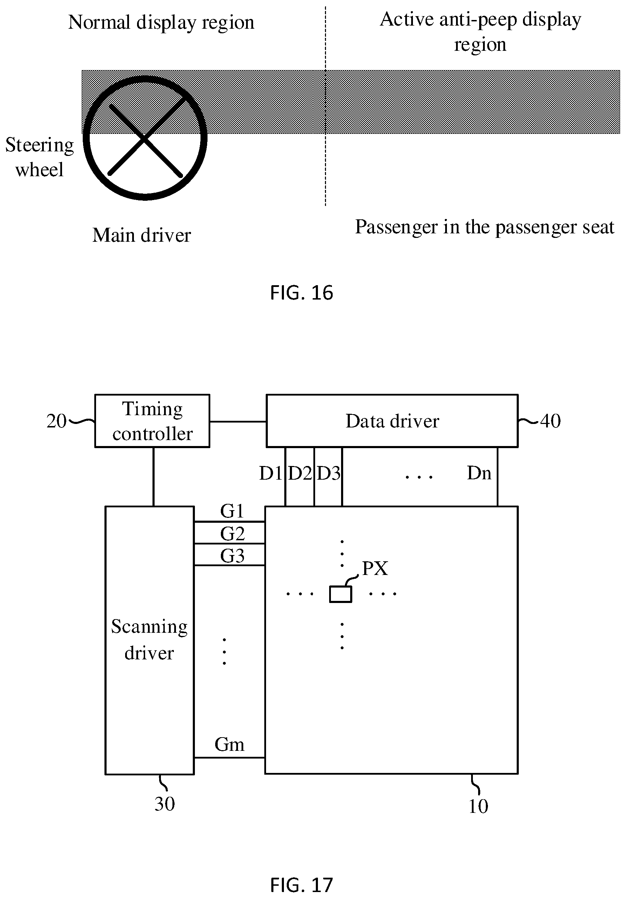

Anti-peep display has new requirements in new scenarios, as shown in FIG. 16, for example, the display screen only needs to have an anti-peep function in a local region, and needs to be displayed normally in other regions. An application scenario is, such as in-vehicle display. The in-vehicle display can be a large horizontal screen, the main driver and the passenger in the passenger seat can share the same screen, the region facing the main driver can be a normal screen, and the region facing the passenger in the passenger seat is required to be an active anti-peep screen (when the vehicle is driven, the passenger in the passenger seat can choose to turn on the active anti-peep while watching the video, to avoid the screen that is viewed by the passenger in the passenger seat from affecting the main driver's driving, thus improving safe driving).

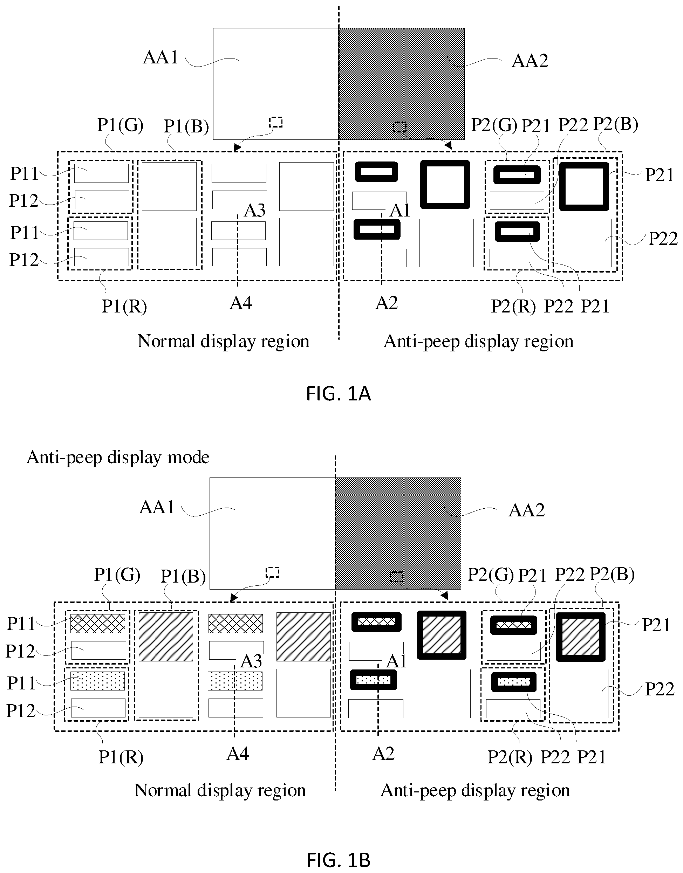

In view of the above, embodiments of the present disclosure provide a display panel, as shown in FIG. 1A, FIG. 5A, or FIG. 9A, the lower-left figure is an enlarged schematic diagram of a dashed frame at the upper-left side, and the lower-right figure is an enlarged schematic diagram of a dashed frame at the upper-right side. The display panel includes: a substrate, having a first display region AA1 and a second display region AA2; specifically, the first display region AA1 may serve as a normal display region, and the second display region AA2 may serve as an anti-peep display region; a plurality of first sub-pixels P1 in the first display region AA1; specifically, the first sub-pixels P1 may include red sub-pixels R, may also include green sub-pixels G, and may also include blue sub-pixels B; and a plurality of second sub-pixels P2 in the second display region AA2; specifically, the second sub-pixels P2 may include red sub-pixels R, may also include green sub-pixels G, and may also include blue sub-pixels B. At least one of the plurality of second sub-pixels P2 includes: a first pixel portion P21 and a second pixel portion P22; and a light-emitting area of the first pixel portion P21 is smaller than a light-emitting area of the second pixel portion P22.

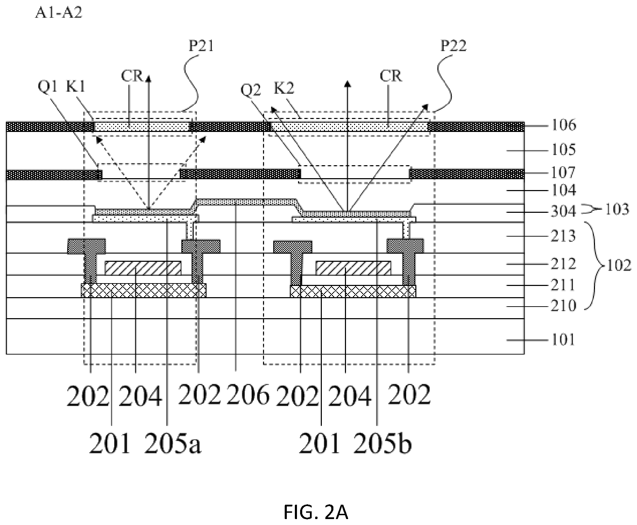

In a possible implementation mode, see FIG. 2A which is a schematic diagram of a cross-section along a dashed line A1A2 in FIG. 1A, the light-emitting area of the first pixel portion P21 and the light-emitting area of the second pixel portion P22 may be controlled by sizes of openings of a light-shielding layer (e.g., a first light-shielding layer 106 in FIG. 2A). For example, in FIG. 2A, the display panel includes: a first shielding layer 106; the first shielding layer 106 includes: a first opening K1, and a second opening K2; an orthographic projection of the first opening K1 on the substrate 101 has an overlapping region with an orthographic projection of the first pixel portion P21 on the substrate 101; an orthographic projection of the second opening K2 on the substrate 101 has an overlapping region with an orthographic projection of the second pixel portion P22 on the substrate 101; and an area of the orthographic projection of the first opening K1 on the substrate 101 is smaller than an area of the orthographic projection of the second opening K2 on the substrate 101, so that a light-emitting area of the first pixel portion P21 is smaller than a light-emitting area of the second pixel portion P22. Combined with FIG. 2A, when the first opening K1 is smaller than the second opening K2, at the region where the first pixel portion P21 is located, due to the first opening K1 being smaller, light from the front viewing angle can be emitted, but light from the side viewing angle will be blocked (herein, a dashed arrow indicates the light that is blocked by the light-shielding layer and fails to be emitted, and a solid arrow indicates the light that is normally emitted); and for light that is emitted from the region where the second pixel portion P22 is located, due to the second opening K2 being larger, the light from the front viewing angle can be emitted, and the light from the side viewing angle can also be emitted. That is, through the control of sizes of the openings of the light-shielding layer at different positions, the angle of emission of the emitted light can be controlled, to further realize the control of anti-peep or normal display.

In the embodiments of the present disclosure, the display panel has a first display region AA1 and a second display region AA2; herein, the second sub-pixel P2 in the second display region AA2 includes a first pixel portion P21 and a second pixel portion P22; and the light-emitting area of the first pixel portion P21 is smaller than the light-emitting area of the second pixel portion P22. Therefore, at the first pixel portion P21, light rays from the front viewing angle are emitted, and light rays from the side viewing angle are blocked; and at the second pixel portion P22, light rays from the front viewing angle and light rays from the side viewing angle can be emitted. So that, when it is necessary to perform the anti-peep display in the second display region AA2, only the first pixel portion P21 is displayed, and thus a viewer who is facing the second display region AA2 is only allowed to view the contents displayed in the second display region AA2, but viewers at other positions cannot view contents displayed in the second display region AA2, realizing the anti-peep display of the second display region AA2. When normal display of the second display region AA2 is required, at least the second pixel portion P22 is displayed, so that a viewer facing the second display region AA2 can view the contents of the second display region AA2, and viewers at other positions can also view the contents of the second display region AA2, thus realizing normal display of the second display region AA2, and thus realizing localized anti-peep display of the second display region AA2. Then, in an application scenario that a display panel needs to realize the localized anti-peep, for example, in the vehicle display, a main driver and a passenger in the passenger seat use the same screen; and when the vehicle is being driven, the passenger in the passenger seat can choose to turn on the active anti-peep while watching the video, to avoid the screen that is viewed by the passenger in the passenger seat from affecting the main driver's driving, thus improving safe driving.

In a possible implementation mode, the light-emitting area of the first sub-pixel portion P21 is smaller than the light-emitting area of the second sub-pixel P22, and the light-emitting area of the first sub-pixel portion P21 may be reduced simultaneously in a row direction of sub-pixels and in a column direction of sub-pixels. Specifically, the light-emitting area of the first pixel portion P21 may be reduced by making the size of the first opening K1 smaller than the size of the second opening K2 in both the row direction of sub-pixels and the column direction of sub-pixels.

In some exemplary implementation modes, the second display region AA2 of the display panel may include an active anti-peep display mode and a normal display mode. The active anti-peep display mode may satisfy the display needs of the passenger in the passenger seat who needs to watch alone, and the normal display mode may satisfy the display needs of the user in an information sharing scenario. In some examples, the display panel may be provided with a switching key, and the user switches the display mode of the second display region AA2 via the switching key. However, it's not limited in the present embodiment. In some other examples, triggering methods such as voice control, induction, etc., may be used to initiate the switching of the display mode of the second display region AA2.

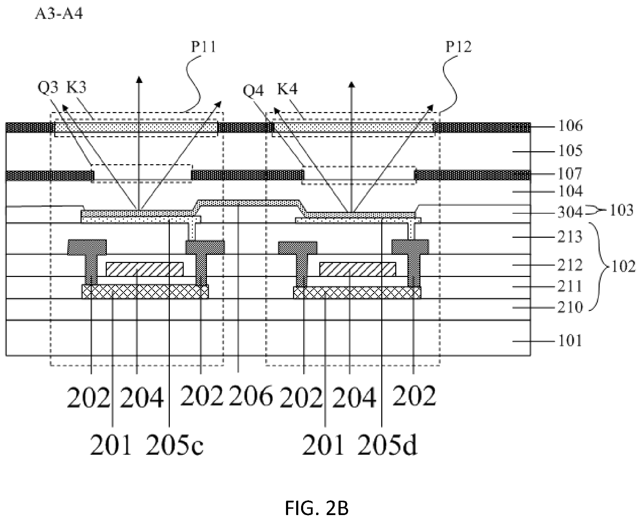

In a possible implementation mode, as shown in FIG. 1A and FIG. 2B, FIG. 2B is a schematic diagram of a cross-section along the dashed line A3A4 in FIG. 1A, at least one of the plurality of first sub-pixels P1 includes: a third pixel portion P11 and a fourth pixel portion P12; and a light-emitting area of the third pixel portion P11 is equal to a light-emitting area of the fourth pixel portion P12.

In a possible implementation mode, the light-emitting area of the third pixel portion P11 and the light-emitting area of the fourth pixel portion P12 can be controlled by the size of the opening of a light-shielding layer (such as, the first light-shielding layer 106 in FIG. 2B). For example, see FIG. 1A and FIG. 2B, the first shielding layer 106 also includes: a third opening K3 and a fourth opening K4; an orthographic projection of the third opening K3 on the substrate 101 has an overlapping region with an orthographic projection of the third pixel portion P21 on the substrate 101; an orthographic projection of the fourth opening K4 on the substrate 101 has an overlapping region with an orthographic projection of the fourth pixel portion P22 on the substrate 101; and an area of the orthographic projection of the third opening K3 on the substrate 101 is equal to an area of the orthographic projection of the fourth opening K4 on the substrate 101, to further realize that the light-emitting area of the third pixel portion P11 is equal to the light-emitting area of the fourth pixel portion P12.

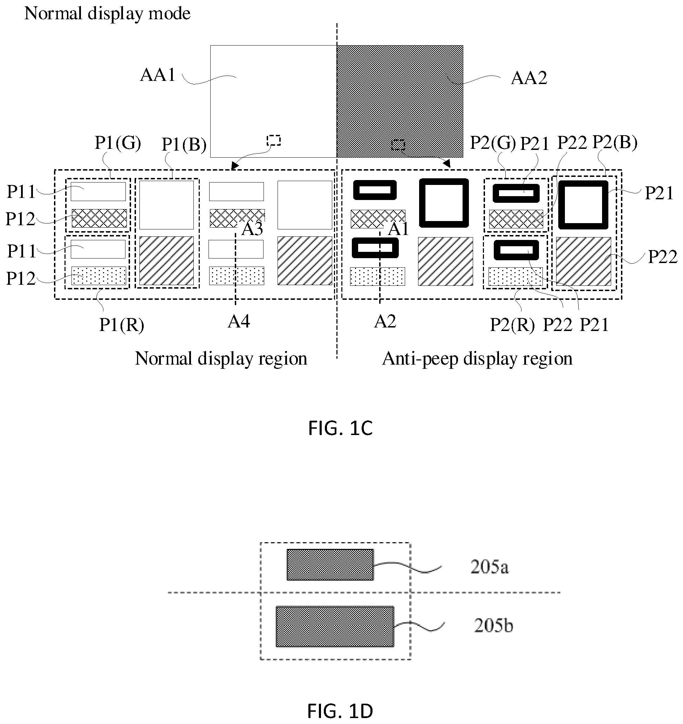

Specifically, shown in conjunction with FIG. 1B and FIG. 1C, FIG. 1B is a schematic diagram of the display panel shown in FIG. 1A in a case of an anti-peep display, and FIG. 1C is a schematic diagram of the display panel shown in FIG. 1A in a case of a normal display. In a case of the anti-peep display, as shown in FIG. 1B, the third pixel portion P11 of the first display region AA1 is displayed and the fourth pixel portion P12 of the first display region AA1 is not displayed, and the first pixel portion P21 of the second display region AA2 is displayed and the second pixel portion P22 of the second display region AA2 is not displayed, thereby enabling the first display region AA1 to be displayed normally and the second display region AA2 to be displayed in an anti-peep mode. In a case of the normal display, as illustrated in FIG. 1C, the third pixel portion P11 of the first display region AA1 is not displayed and the fourth pixel portion P12 of the first display region AA1 is displayed, and the first pixel portion P21 of the second display region AA2 is not displayed and the second pixel portion P22 of the second display region AA2 is displayed, so that both the first display region AA1 and the second display region AA2 can be displayed normally. Furthermore, in a case of the normal display, only the fourth pixel portion P12 of the first display region AA1 is displayed and the second pixel portion P22 of the second display region AA2 is displayed, so that the visual difference between the first display region AA1 and the second display region AA2 can be made smaller.

In a possible implementation mode, in a case of the normal display, it may also be possible to display both the first display region AA1 and the second display region AA2 normally by causing the third pixel portion P11 of the first display region AA1 to be displayed and the fourth pixel portion P12 of the first display region AA1 not to be displayed, and by causing the first pixel portion P21 of the second display region AA2 not to be displayed and the second pixel portion P22 of the second display region AA2 to be displayed.

In a possible implementation mode, it is possible to make the light-emitting area of the third pixel portion P11 and the light-emitting area of the fourth pixel portion P12 both equal to the light-emitting area of the second pixel portion P22. Specifically, the area of the orthographic projection of the fourth opening K4 on the substrate 101 may be equal to the area of the orthographic projection of the second opening K2 on the substrate 101. Therefore, in the case of the normal display, the visual difference between the first display region AA1 and the second display region AA2 may be made smaller by displaying only the fourth pixel portion P12 of the first display region AA1 and the second pixel portion P22 of the second display region AA2.

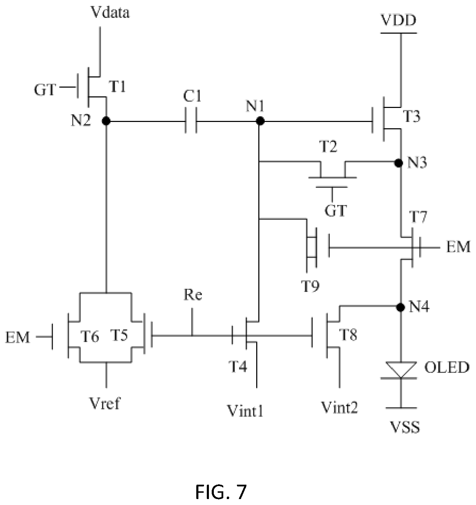

In a possible implementation mode, after segmenting the second sub-pixel P2 of the second display region AA2 shown in FIG. 1A, it is also possible to drive the first pixel portion P21 and the second pixel portion P22 of the sub-pixel P2 separately by different pixel circuits. For example, it is possible to drive by the circuit shown in FIG. 7.

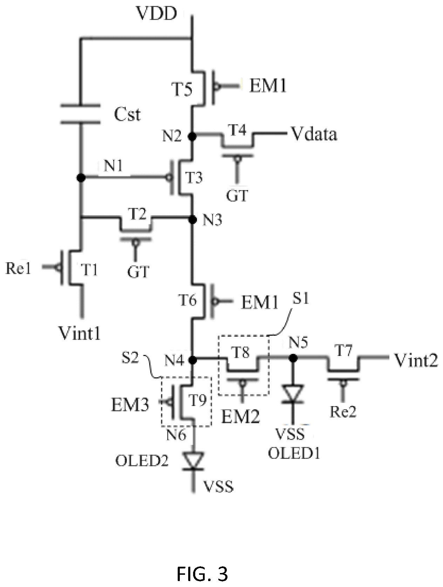

In another possible implementation mode, after segmenting the second sub-pixel P2 of the second display region AA2 shown in FIG. 1A, the first pixel portion P21 and the second pixel portion P22 of the same sub-pixel P2 can be driven to emit light by the same pixel circuit. That is, specifically, as shown in FIG. 3, the second sub-pixel P2 includes: a second pixel circuit; and a first anode portion 205a and a second anode portion 205b are both electrically connected to the second pixel circuit. By driving the first pixel portion P21 and the second pixel portion P22 of the same sub-pixel P2 to emit light through the same pixel driving circuit, the circuit wiring space of the display panel can be saved and the cost of the display panel can be reduced.

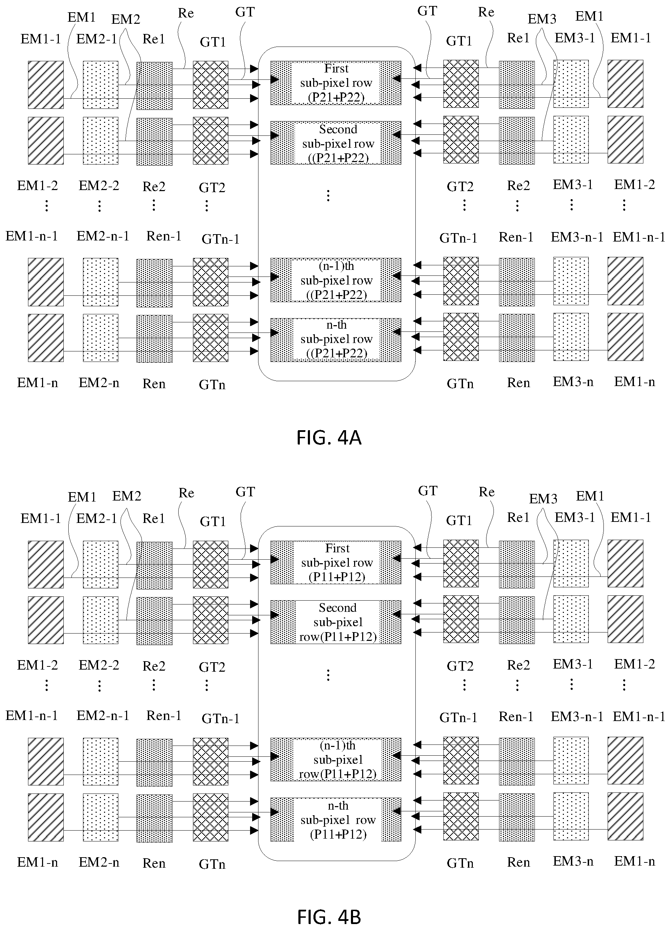

In a possible implementation mode, see FIG. 3, FIG. 4A and FIG. 4B, FIG. 4A is a schematic diagram of the wiring connection corresponding to the second display region AA2, and FIG. 4B is a schematic diagram of the wiring connection corresponding to the first display region AA1. The second pixel circuit includes at least a first light-emitting control sub-circuit S1 and a second light-emitting control sub-circuit S2. The display panel further includes: a first light-emitting control line EM2, and a second light-emitting control line EM3. The first light-emitting control sub-circuit S1 is electrically connected to the first light-emitting control line EM2 and the first pixel portion P21 (which may specifically be the first anode portion 205a in the first pixel portion P21), and is configured to drive the first pixel portion P21 to emit light under the control of the first light-emitting control line EM2. The second light-emitting control sub-circuit S2 is electrically connected to the second light-emitting control line and the second pixel portion P22 (which may specifically be the second anode portion 205b in the second pixel portion P22), and is configured to drive the second pixel portion P22 to emit light under the control of the second light-emitting control line EM3.

Specifically, shown in conjunction with FIG. 4A or FIG. 4B, the display panel further includes: a gate drive circuit; and the gate drive circuit may specifically include: a first sub-circuit (EM1-1......EM1-n), a second sub-circuit (EM2-1......EM2-n), a third sub-circuit (EM3-1......EM3-n), a fourth sub-circuit (Re1......Ren), and a fifth sub-circuit (GT1......GTn). Herein, the second sub-circuit (EM2-1......EM2-n) can provide a first light-emitting control signal for the sub-pixel row and transmit the first light-emitting control signal to the sub-pixel row via the first light-emitting control line EM2, the third sub-circuit (EM3-1......EM3-n) can provide a second light-emitting control signal for the sub-pixel row and transmit the second light-emitting control signal to the sub-pixel row via the second light-emitting control line EM3, the first sub-circuit (EM1-1......EM1-n) can provide a third light-emitting control signal for the sub-pixel row and transmit the third light-emitting control signal to the sub-pixel row via the third light-emitting control line EM1, the fourth sub-circuit (Re1 ......Ren) can provide a reset signal for the sub-pixel row and transmit the reset signal to the sub-pixel row via the reset signal line Re, and the fifth sub-circuit (GT1......GTn) can provide a scan signal for the sub-pixel row and transmit the scan signal to the sub-pixel row via the scan signal line GT. Specifically, the first sub-circuit (EM1-1......EM1-n) may include transistors and/or capacitors, the second sub-circuit (EM2-1......EM2-n) may include transistors and/or capacitors, the third sub-circuit (EM3-1 ......EM3-n) may include transistors and/or capacitors, the fourth sub-circuit (Re1......Ren) may include transistors and/or capacitors, and the fifth sub-circuit (GT1... ...GT n) may include transistors and/or capacitors.

In some examples, the first pixel portion P21 may include a first anode portion 205a, a first organic light-emitting layer and a first cathode which are stacked. The second pixel portion P22 may include a second anode portion 205b, a second organic light-emitting layer and a second cathode which are stacked. The first cathode of the first pixel portion P21 may be electrically connected to a second power line VSS. The second cathode of the second pixel portion P22 may be electrically connected to the second power line VSS. In some examples, as shown in FIG. 1D, a first anode portion 205a of the first pixel portion P21 and a second anode portion 205b of the second pixel portion P22 may be obtained by dividing the anode of the second sub-pixel P2 (e.g., by dividing the anode along the dotted line in FIG. 1D).

In some examples, a first power line VDD may be configured to continuously provide a first voltage signal at a high potential, and the second power line VSS may be configured to continuously provide a second voltage signal at a low potential. The first voltage signal is greater than the second voltage signal.

In some examples, a plurality of transistors of the pixel circuit may utilize low temperature poly-silicon thin-film transistors, or may utilize oxide thin-film transistors, or may utilize low temperature poly-silicon thin-film transistors and oxide thin-film transistors. An active layer of the low temperature poly-silicon thin-film transistor uses the low temperature poly-silicon (LTPS), and an active layer of the oxide thin-film transistor uses oxide. The low temperature poly-silicon thin-film transistor has advantages such as high mobility and fast charging, and the oxide thin-film transistor has advantages such as a low leakage current. In some examples, the low temperature poly-silicon thin-film transistors and the oxide thin-film transistors can be integrated in one display panel to form a low-temperature polycrystalline oxide display panel, which can take advantages of both, realize high resolution (PPI, Pixel Per Inch) and the low-frequency driving, reduce power consumption, and improve the display quality. However, the present embodiment is not limited thereto.

FIG. 3 is an equivalent circuit diagram of a pixel circuit of at least one embodiment of the present disclosure. In some examples, the pixel circuit may be a 9T1C structure, as shown in FIG. 3. Herein, the pixel circuit may include: a first transistor T1, a second transistor T2, a third transistor T3, a fourth transistor T4, a fifth transistor T5, a sixth transistor T6, a seventh transistor T7, an eighth transistor T8, a ninth transistor T9, and a storage capacitor Cst. Herein, a first light-emitting control sub-circuit S1 may include the eighth transistor T8; and a second light-emitting control sub-circuit S2 may include the ninth transistor T9. In the circuit structure shown in FIG. 3, the first transistor T1 may be a reset transistor, the second transistor T2 may be a threshold compensation transistor, the third transistor T3 may be a driver transistor, the fourth transistor T4 may be a data writing transistor, the fifth transistor T5 may be a light-emitting control transistor, the sixth transistor T6 may be a light-emitting control transistor, the seventh transistor T7 may be a reset transistor, the eighth transistor T8 may be a light-emitting control transistor, and the ninth transistor T9 may be a light-emitting control transistor.

In some examples, as shown in FIG. 3, a gate of the first transistor T1 is electrically connected to a first reset control line Re1, a first pole of the first transistor T1 is electrically connected to a first initial signal line Vint1, and a second pole of the first transistor T1 is electrically connected to a first node N1. A gate of the second transistor T2 is electrically connected to the scan line GT, a first pole of the second transistor T2 is electrically connected to the first node N1, and a second pole of the second transistor T2 is electrically connected to a third node N3. A gate of the third transistor T3 is electrically connected to the first node N1, a first pole of the third transistor T3 is electrically connected to the second node N2, and a second pole of the third transistor T3 is electrically connected to the third node N3. A gate of the fourth transistor T4 is electrically connected to the scan line GT, a first pole of the fourth transistor T4 is electrically connected to a data line Vdata, and a second pole of the fourth transistor T4 is electrically connected to the second node N2. A gate of the fifth transistor T5 is electrically connected to the third light-emitting control line EM1, a first pole of the fifth transistor T5 is electrically connected to the first power line VDD, and a second pole of the fifth transistor T5 is electrically connected to the second node N2. A gate of the sixth transistor T6 is electrically connected to the third light-emitting control line EM1, a first pole of the sixth transistor T6 is electrically connected to the third node N3, and a second pole of the sixth transistor T6 is electrically connected to a fourth node N4. A gate of the seventh transistor T7 is electrically connected to the second reset control line Re2, a first pole of the seventh transistor T7 is electrically connected to the second initial signal line Vint2, and a second pole of the seventh transistor T7 is electrically connected to a fifth node N5 (that is, electrically connected to the first anode portion 205a of the first pixel portion P21). A gate of the eighth transistor T8 is electrically connected to the first light-emitting control line EM2, a first pole of the eighth transistor T8 is electrically connected to the fourth node N4, and a second pole of the eighth transistor T8 is electrically connected to the first anode portion 205a of the first pixel portion P21. A gate of the ninth transistor T9 is electrically connected to the second light-emitting control line EM3, a first pole of the ninth transistor T9 is electrically connected to the fourth node N4, and a second pole of the ninth transistor T9 is electrically connected to the second anode portion 205b of the second pixel portion P22. A first pole plate of the storage capacitor Cst is electrically connected to the first node N1, and a second pole of the storage capacitor Cst is electrically connected to the first power line VDD.

In some examples, the first node N1 is a connection point of the first transistor T1, the second transistor T2, the third transistor T3 and the storage capacitor Cst. The second node N2 is a connection point of the third transistor T3, the fourth transistor T4 and the fifth transistor T5. The third node N3 is a connection point of the third transistor T3, the second transistor T2 and the sixth transistor T6. The fourth node N4 is a connection point of the sixth transistor T6, the eighth transistor T8 and the ninth transistor T9. The fifth node N5 is a connection point of the seventh transistor T7, the eighth transistor T8, and the first anode portion 205a of the first pixel portion P21.

In some examples, it is illustrated that nine transistors of the pixel circuit are all P-type transistors. Herein, the second reset control line Re2 may be connected to the scan line GT to be input with a scan signal. In the localized anti-peek mode, the first light-emitting control line EM2 may continuously provide a low-level signal, so that the third control transistor T8 is turned on and the first pixel portion P21 is in a luminous state; and the second light-emitting control line EM3 may continuously provide a high-level signal, so that the fourth control transistor T9 is turned off and the second pixel portion P22 is in the non-luminous state. In the sharing (normal) display mode, the first light-emitting control line EM2 may continuously provide a high-level signal, so that the third control transistor T8 is turned off and the first pixel portion P21 is in a non-luminous state; and the second light-emitting control line EM3 may continuously provide a low-level signal, so that the fourth control transistor T9 is turned on and the second pixel portion P22 is in a luminous state.

The above pixel circuit is only an example. The embodiment does not limit the structure of the pixel circuit.

After segmenting the first sub-pixel P1 of the first display region AA1 shown in FIG. 1A, the third pixel portion P11 and the fourth pixel portion P12 of the same first sub-pixel P1 can be driven to emit light by the same pixel circuit; the first sub-pixel P1 includes: a first pixel circuit; and a third anode portion 205c and a fourth anode portion 205d are both electrically connected to the first pixel circuit. The structure of the first pixel circuit may be consistent with the circuit structure shown in FIG. 3, and their driving processes are similar, which will not be repeated here.

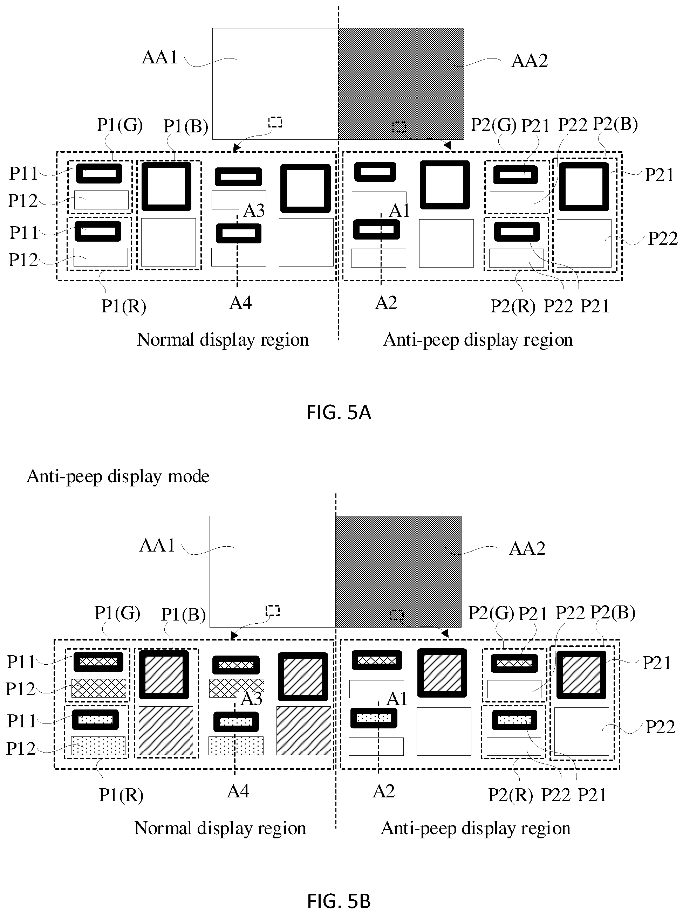

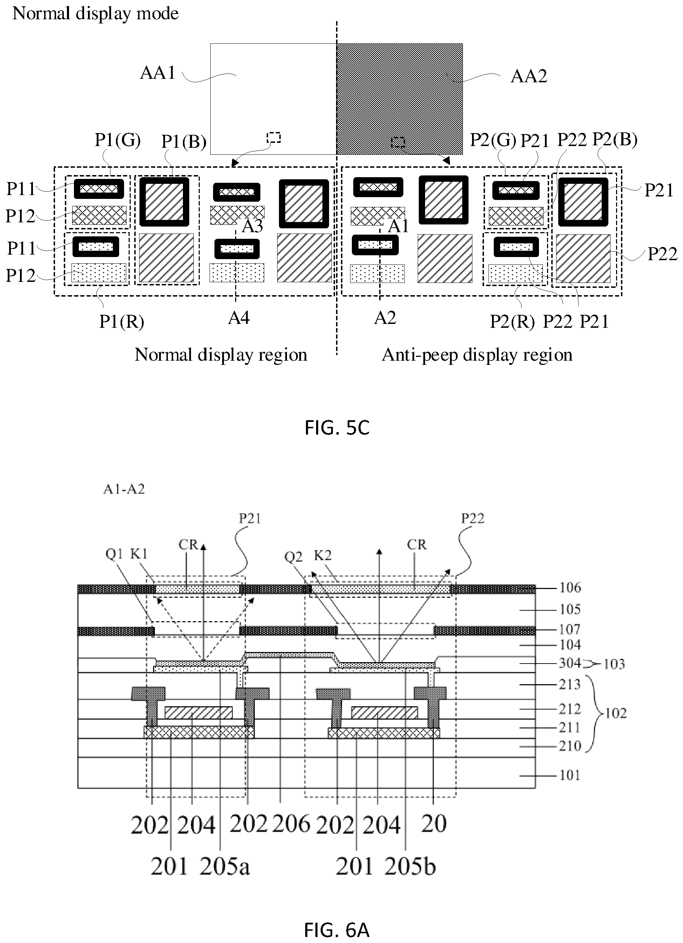

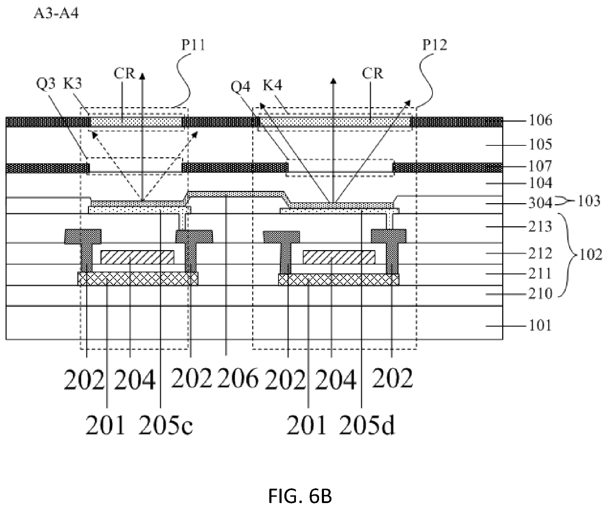

In a possible implementation mode, see FIG. 5A, FIG. 6A and FIG. 6B, FIG. 6A may be a schematic diagram of a cross-section along a dashed line A1A2 in FIG. 5A, and FIG. 6B may be a schematic diagram of a cross-section along a dashed line A3A4 in FIG. 5A. At least one of the plurality of first sub-pixels P1 includes: a third pixel portion P11 and a fourth pixel portion P12; and an emitting area of the third pixel portion P11 is smaller than an emitting area of the fourth pixel portion P12.

In a possible implementation mode, see FIGS. 5A, 6A and 6B, at least one of the plurality of first sub-pixels P1 includes: a third pixel portion P21 and a fourth pixel portion P22; the first shielding layer 106 further includes: a third opening K3 and a fourth opening K4; an orthographic projection of the third opening K3 on the substrate 101 has an overlapping region with an orthographic projection of the third pixel portion P21 on the substrate 101; and an orthographic projection of the fourth opening K4 on the substrate 101 has an overlapping area with an orthographic projection of the fourth pixel portion P22 on the substrate 101. An area of the orthographic projection of the third opening K3 on the substrate 101 is smaller than an area of the orthographic projection of the fourth opening K4 on the substrate 101, so that the light-emitting area of the third pixel portion P11 is smaller than the light-emitting area of the fourth pixel portion P12.

In the embodiments of the present disclosure, for the first display region AA1 that needs to be displayed normally, the first sub-pixel P1 may also be divided, for example, into a third pixel portion P11 and a fourth pixel portion P12. The light-emitting area of the third pixel portion P11 is smaller than the light-emitting area of the fourth pixel portion P12, so that the visual (e.g., brightness) difference between the first display region AA1 and the second display region AA2 can be reduced when the first display region AA1 and the second display region AA2 are displayed normally.

Specifically, as shown in conjunction with FIGS. 5B and 5C, FIG. 5B is a schematic diagram of the display panel in FIG. 5A in a case of the anti-peep display, and FIG. 5C is a schematic diagram of the display panel in FIG. 5A in a case of the normal display. In a case of the anti-peep display, as shown in FIG. 5B, the third pixel portion P11 of the first display region AA1 is displayed and the fourth pixel portion P12 of the first display region AA1 is also displayed, and the first pixel portion P21 of the second display region AA2 is displayed and the second pixel portion P22 of the second display region AA2 is not displayed, thereby enabling the first display region AA1 to be displayed normally and the second display region AA2 to be displayed in an anti-peep mode. In the case of the normal display, as shown in FIG. 5C, the third pixel portion P11 of the first display region AA1 is displayed and the fourth pixel portion P12 of the first display region AA1 is displayed, and the first pixel portion P21 of the second display region AA2 is displayed and the second pixel portion P22 of the second display region AA2 is also displayed, so that the first display region AA1 and the second display region AA2 are both displayed normally. Furthermore, the third pixel portion P11 and the fourth pixel portion P12 of the first display region AA1 are both displayed during the anti-peep display, which can avoid the problem of limited brightness due to the small light-emitting area of each first sub-pixel P1 in the first display region AA1 when only the third pixel portion P11 is displayed. During the normal display, the third pixel portion P11 and the fourth pixel portion P12 of the first display region AA1 are all displayed, and the first pixel portion P21 and the second pixel portion P22 of the second display region AA2 are all displayed, so that the visual difference between the first display region AA1 and the second display region AA2 can be made smaller.

In a possible implementation mode, in a case of the anti-peep display, the third pixel portion P11 of the first display region AA1 is displayed and the fourth pixel portion P12 of the first display region AA1 is not displayed, and the first pixel portion P21 of the second display region AA2 is displayed and the second pixel portion P22 of the second display region AA2 is not displayed, so that the first display region AA1 can be displayed normally and the second display region AA2 can be displayed in an anti-peep mode.

In a possible implementation mode, for the display panel shown in FIG. 5A, after segmenting the second sub-pixel P2 of the second display region AA2, the first pixel portion P21 and the second pixel portion P22 of the same sub-pixel P2 can be driven to emit light by the same pixel circuit, e.g., the circuit shown in FIG. 3 can be used to drive the first pixel portion P21 and the second pixel portion P22 to emit light.

In a possible implementation mode, for the display panel shown in FIG. 5A, after segmenting the second sub-pixel P2 of the second display region AA2, the first pixel portion P21 and the second pixel portion P22 of the same sub-pixel P2 may be driven to emit light by different pixel circuits. The first pixel portion P21 is driven by one pixel circuit and the second pixel portion P22 is driven by another pixel circuit. That is, specifically, the second sub-pixel includes: a first sub-pixel circuit and a second sub-pixel circuit; a first anode portion 205a is electrically connected to the first sub-pixel circuit P21; and a second anode portion 205b is electrically connected to the second sub-pixel circuit P22.

In a possible implementation mode, structures of the first sub-pixel circuit and the second sub-pixel circuit may be shown in FIG. 7, including: a first transistor T1, a second transistor T2, a third transistor T3, a fourth transistor T4, a fifth transistor T5, a sixth transistor T6, a seventh transistor T7, an eighth transistor T8, a ninth transistor T9, and a first capacitor C1. Herein, a gate of the first transistor T1 is electrically connected to the scan line GT, a first pole of the first transistor T1 is electrically connected to the data line Vdata, and a second pole of the first transistor T1 is electrically connected to the second node N2. A gate of the second transistor T2 is electrically connected to the scan line GT, a first pole of the second transistor T2 is electrically connected to the first node N1, and a second pole of the second transistor T2 is electrically connected to the third node N3. A gate of the third transistor T3 is electrically connected to the first node, a second pole of the third transistor T3 is electrically connected to a first power line VDD, and a second pole of the third transistor T3 is electrically connected to the third node N3. A gate of the fourth transistor T4 is electrically connected to a reset signal line Re, a first pole of the fourth transistor T4 is electrically connected to a first initial signal line Vint, and a second pole of the fourth transistor T4 is electrically connected to the first node N1. A gate of the fifth transistor T5 is electrically connected to the reset signal line Re, a first pole of the fifth transistor T5 is electrically connected to the reference signal line Vref, and a second pole of the fifth transistor T5 is electrically connected to the second node N2. A gate of the sixth transistor T6 is electrically connected to a first pixel row control line EMO (or a second pixel row control line EME; it is electrically connected to the first pixel row control line EMO if the sub-pixel portion is located in the first pixel row P100, or it is electrically connected to the second pixel row control line EME if the sub-pixel portion is located in the second pixel row P200), a first pole of the sixth transistor T6 is electrically connected to the reference signal line Vref, and a second pole of the sixth transistor T6 is electrically connected to the second node N2. A gate of the seventh transistor T7 is electrically connected to the first pixel row control line EMO (or the second pixel row control line EME, it is electrically connected to the first pixel row control line EMO if the sub-pixel portion is located in the first pixel row P100, or it is electrically connected to the second pixel row control line EME if the sub-pixel portion is located in the second pixel row P200), a first pole of the seventh transistor T7 is electrically connected to the third node N3, and a second pole of the seventh transistor T7 is electrically connected to the fourth node N4. A gate of the eighth transistor T8 is electrically connected to the reset signal line Re, a first pole of the eighth transistor T8 is electrically connected to the second initial signal line Vint2, and a second pole of the eighth transistor T8 is electrically connected to the fourth node N4. A gate of the ninth transistor T9 is electrically connected to the first pixel row control line EMO (or the second pixel row control line EME; it is electrically connected to the first pixel row control line EMO if the sub-pixel portion is located in the first pixel row P100, or it is electrically connected to the second pixel row control line EME if the sub-pixel portion is located in the second pixel row P200), and a first pole and a second pole of the ninth transistor T9 are electrically connected to the first node N1. A first end of the first capacitor C1 is electrically connected to the first node N1, and a second end of the first capacitor C1 is electrically connected to the second node N2. A first anode portion 205a of the first pixel portion P21 (or a second anode portion 205b of the second pixel portion P22, or a third anode portion 205c of the third pixel portion P11, or a fourth anode portion 205d of the fourth pixel portion P12) is electrically connected to the fourth node N4, and a cathode of the first pixel portion P21 (or a cathode of the second pixel portion P22, or a cathode of the third pixel portion P11, or a cathode of the fourth pixel portion P12) is electrically connected to the second power signal line VSS.

In some examples, the first node N1 is a connection point of the first capacitor C1, the second transistor T2, the third transistor T3, the fourth transistor T4, and the ninth transistor T9. The second node N2 is a connection point of the first transistor T1, the fifth transistor T5, the sixth transistor T6, and the first capacitor C1. The third node N3 is a connection point of the third transistor T3, the second transistor T2, and the seventh transistor T7. The fourth node N4 is a connection point of the seventh transistor T7, the eighth transistor T8, and the first anode portion 205a of the first pixel portion P21 (or the second anode portion 205b of the second pixel portion P22, or the third anode portion 205c of the third pixel portion P11, or the fourth anode portion 205d of the fourth pixel portion P12).

The driving light-emitting process of the 9T1C pixel circuit shown in FIG. 7 may be similar to the driving light-emitting process of the conventional 9T1C pixel circuit, which is not be repeated in the embodiments of the present disclosure.

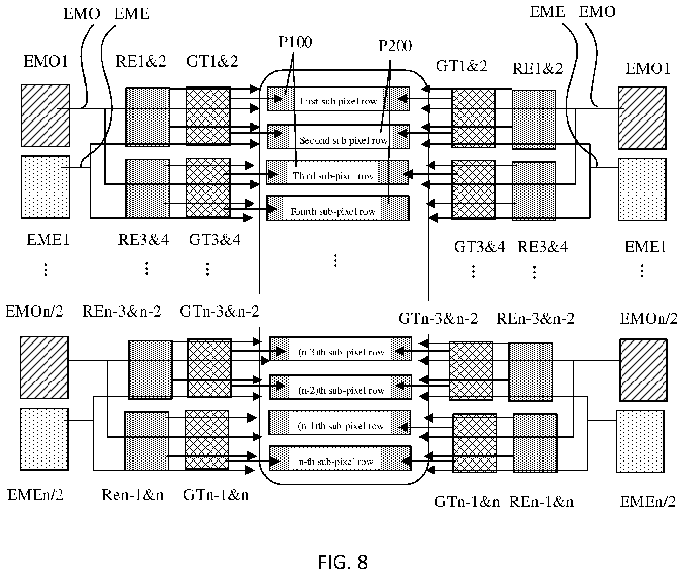

In a possible implementation mode, see FIG. 8, a plurality of second sub-pixels P2 include: first pixel rows P100 (e.g., an odd number of pixel rows may be used as the first pixel rows), and second pixel rows P200 (e.g., an even number of pixel rows may be used as the second pixel rows); the first pixel rows P100 and the second pixel rows P200 extend in a first direction X and are alternately arranged in a second direction Y; the first pixel row P100 includes: a plurality of first pixel portions P21; and the second pixel row P200 includes: a plurality of second pixel portions P22.

The display panel further includes: a first pixel row control line EMO, and a second pixel row control line EME; the first pixel row control line EMO is electrically connected to the first pixel portions P21 of the first pixel row P100, and the second pixel row control line EME is electrically connected to the second pixel portions P22 of the second pixel row P200; and the first pixel row control line EMO is configured to provide a signal to the first pixel portions P21 of the first pixel row P100, and the second pixel row control line EME is configured to provide a signal to the second pixel portions P22 of the second pixel row P200.

In a possible implementation mode, the first direction X may be a row direction of sub-pixels, and the second direction Y may be a column direction of sub-pixels. In a possible implementation mode, the first direction X may be a direction pointing from the first display region AA1 to the second display region AA2, and the second direction Y may be a direction perpendicular to the first direction X.

In a possible implementation mode, the first pixel row P100 may further include a plurality of third pixel portions P11 of the first sub-pixels P1, and the second pixel row P200 may further include a plurality of fourth pixel portions P12 of the first sub-pixels P1. That is, the third pixel portions P11 of the first display region AA1 and the first pixel portions P21 of the second display region AA2 are located in an odd number of rows, and are provided with a signal by the first pixel row control line EMO; and the fourth pixel portions P12 of the first display region AA1 and the second pixel portions P22 of the second display region AA2 are located in an even number of rows, and are provided with a signal by the second pixel row control line EME.

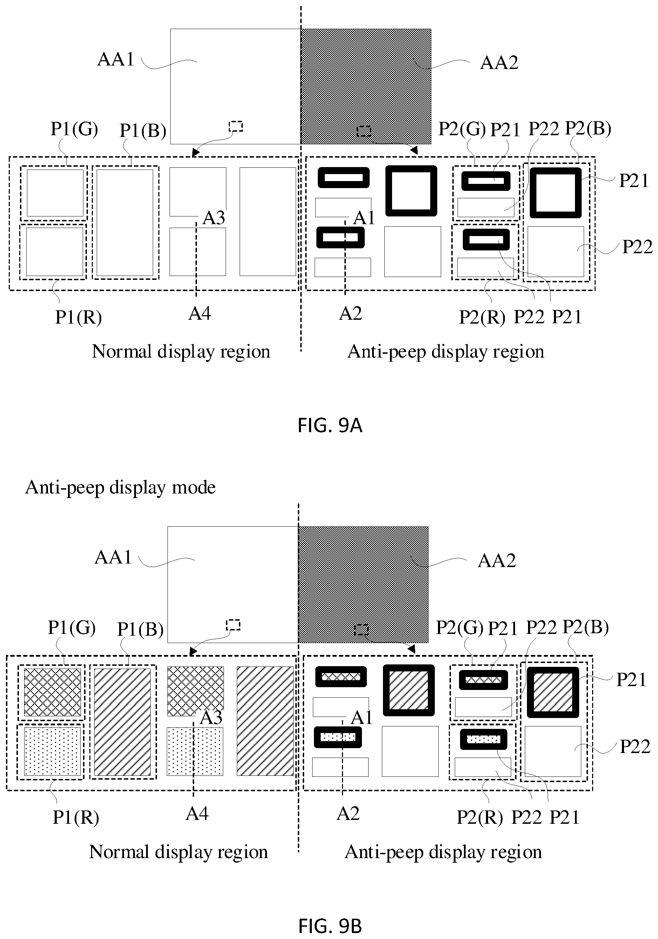

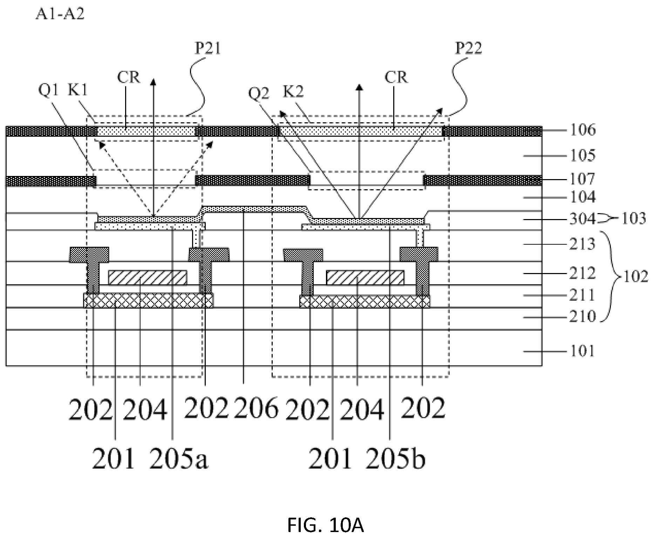

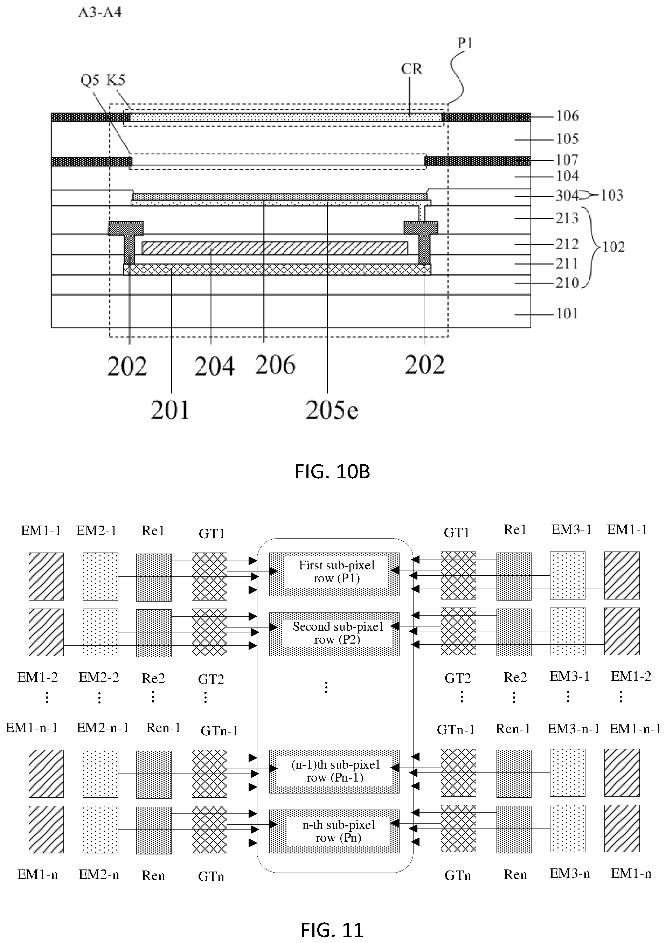

In a possible implementation mode, see FIGS. 9A, 10A and 10B, at least one of the plurality of first sub-pixels P1 is of an one-piece connection structure. That is, the first sub-pixel P1 of the first display region AA1 may be a sub-pixel without segmentation, and is the same as the sub-pixel of a conventional display panel. Specifically, shown in conjunction with FIG. 9A, FIG. 10A and FIG. 10B, the first shielding layer 106 further includes: a fifth opening K5; and an orthographic projection of the fifth opening K5 on the substrate 101 has an overlapping region with an orthographic projection of the first sub-pixel P1 on the substrate 101. That is, the fifth opening K5 may correspond to a first sub-pixel P1 that is not segmented of the first display region AA1.

In the embodiments of the present disclosure, for the first display region AA1 which is required to be displayed normally, the first sub-pixel P1 may also not be segmented, i.e., the first sub-pixel P1 is of an one-piece connection structure; and the second sub-pixel of the second display region AA2 may only be segmented, to reduce the difficulty of fabrication of the display panel.

In a possible implementation mode, for the display panel shown in FIG. 9A, after segmenting the second sub-pixel P2 of the second display region AA2, in a possible implementation mode, the first pixel portion P21 and the second pixel portion P22 may be driven by the same pixel circuit, and the specific pixel circuit may be shown in FIG. 3; and in another possible implementation mode, the first pixel portion P21 and the second pixel portion P22 may be driven by different pixel circuits, and specifically each pixel circuit may be as shown in FIG. 7. For the first sub-pixel P1 that is not segmented of the first display region AA1, in a possible implementation mode, the first sub-pixel P1 is driven by the pixel circuit shown in FIG. 7 specifically.

In a possible implementation mode, for the display panel shown in FIG. 9A, the first sub-pixel P1 of the first display region AA1 is not segmented, and the second sub-pixel P2 of the second display region AA2 is segmented. For the second display region AA2, the connection relationship of signal wires in the display panel may be shown in FIG. 4A. For the first display region AA1, the connection relationship of signal wires in the display panel may be shown in FIG. 11; and unlike FIG. 4A, there is only the first sub-pixel P1 in a row of sub-pixels, instead of the first pixel portion P21 and the second pixel portion P22 after being segmented.

In a possible implementation mode, see FIG. 9A, FIG. 10A and FIG. 10B, a light-emitting area of the first sub-pixel P1 is greater than or equal to a sum of light-emitting areas of the first sub-pixel portion P21 and the second pixel portion P22. Specifically, an area of the orthographic projection of the fifth opening K5 on the substrate 101 is greater than or equal to a sum of an area of the orthographic projection of the first opening K1 on the substrate 101 and an area of the orthographic projection of the second opening K2 on the substrate 101. In this way, the first display region AA1 which is normally displayed can have the higher brightness and a better display effect.

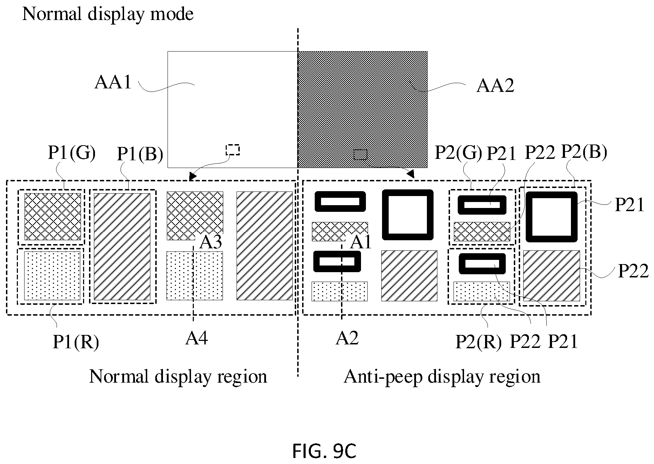

Specifically, as shown in conjunction with FIGS. 9B and 9C, FIG. 9B is a schematic diagram of the display panel in FIG. 9A in a case of the anti-peep display, and FIG. 9C is a schematic diagram of the display panel in FIG. 9A in a case of the normal display. In a case of the anti-peep display, as shown in FIG. 9B, the first sub-pixel P1 of the first display region AA1 is displayed, and the first pixel portion P21 of the second display region AA2 is displayed and the second pixel portion P22 of the second display region AA2 is not displayed, thereby enabling the first display region AA1 to be displayed normally and the second display region AA2 to be displayed in the anti-peep mode. In a case of the normal display, as shown in FIG. 9C, the first sub-pixel P1 of the first display region AA1 is displayed, and the first pixel portion P21 of the second display region AA2 is not displayed and the second pixel portion P22 of the second display region AA2 is displayed, thereby enabling the first display region AA1 and the second display region AA2 to be displayed normally.

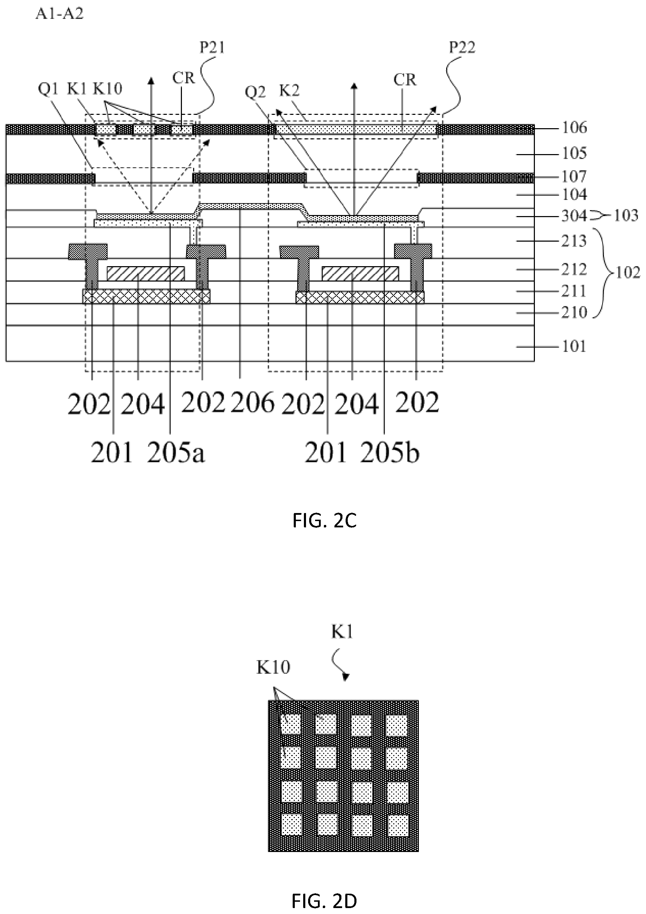

In a possible implementation mode, see FIG. 2C and FIG. 2D, where FIG. 2D is a schematic diagram of distribution of a plurality of first sub-openings K10 at the first opening K1 in FIG. 2C, the first opening K1 includes: a plurality of first sub-openings K10; and the plurality of first sub-openings K10 of the first opening K1 are distributed in an array. In this way, it is possible to limit the exit angle of the first opening K1, which is conducive to realizing the anti-peep effect.

In a possible implementation mode, patterns of orthographic projections of the first sub-openings K10 on the substrate 101 are at least one of a rectangle, a hexagon, an octagon, a circle, or an ellipse.

In a possible implementation mode, patterns of orthographic projections of the first openings K1 on the substrate 101 may be at least one of a rectangle, a hexagon, an octagon, a circle, or an ellipse. In a possible implementation mode, patterns of orthographic projections of the second openings K2 on the substrate 101 may be at least one of a rectangle, a hexagon, an octagon, a circle, or an ellipse. In a possible implementation mode, patterns of orthographic projections of the first light outlets Q1 on the substrate 101 may be at least one of a rectangle, a hexagon, an octagon, a circle, or an ellipse. In a possible implementation mode, patterns of orthographic projections of the second light outlets Q2 on the substrate 101 may be at least one of a rectangle, a hexagon, an octagon, a circle, or an ellipse.

In a possible implementation mode, shown in conjunction with FIG. 2A, the first pixel portion P21 includes: a first anode portion 205a; the second pixel portion includes: a second anode portion 205b; and an area of the orthographic projection of the first anode portion 205a on the substrate 101 is smaller than an area of the orthographic projection of the second anode portion 205b on the substrate 101, so as to adapt to enable the light-emitting area of the first pixel portion P21 to be smaller than the light-emitting area of the second pixel portion P22.

In a possible implementation mode, shown in conjunction with FIG. 2B, at least one of the plurality of first sub-pixels P1 includes: a third pixel portion P11 and a fourth pixel portion P12; the third pixel portion P11 includes a third anode portion 205c, and the fourth pixel portion P12 includes a fourth anode portion 205d; and an area of the orthographic projection of the third anode portion 205c on the substrate 101 is the same as an area of the orthographic projection of the fourth anode portion 205d on the substrate 101, and both are equal to an area of the orthographic projection of the second anode portion 205b on the substrate 101.

In a possible implementation mode, as shown in conjunction with FIG. 10B, at least one of the plurality of first sub-pixels P1 is of an one-piece connection structure; the first sub-pixel portion P1 includes: a fifth anode portion 205e; and an area of an orthographic projection of the fifth anode portion 205e on the substrate 101 is greater than or equal to a sum of an area of an orthographic projection of the first anode portion 205a and an area of an orthographic projection of the second anode portion 205b.

In a possible implementation mode, shown in conjunction with FIG. 2A, the display panel further includes: a second light-shielding layer 107 disposed on a side of the first light-shielding layer 106 facing the substrate 101; the second light-shielding layer 107 includes: a first light outlet Q1, and a second light outlet Q2; an orthographic projection of the first light outlet Q1 on the substrate 101 has an overlapping region with the orthographic projection of the first opening K1 on the substrate 101; and an orthographic projection of the second light outlet Q2 on the substrate 101 has an overlapping region with the orthographic projection of the second opening K2 on the substrate 101. In embodiments of the present disclosure, by providing two light-shielding layers (i.e., the first light-shielding layer 106 and the second light-shielding layer 107), the exit angle of the first sub-pixel portion P21 (or the second sub-pixel portion P22, or the third sub-pixel portion P11, or the fourth sub-pixel portion P22) can be limited (e.g., the anti-peep viewing angle limited by only the first light-shielding layer 106 may be only 60 degrees, and by adding the second light-shielding layer 107, the anti-peek viewing angle may be reduced to 30 degrees), thereby facilitating the realization of the anti-peek effect.

In a possible implementation mode, an area of the orthographic projection of the first light outlet Q1 on the substrate 101 may be smaller than an area of the orthographic projection of the first opening K1 on the substrate 101, and an area of the orthographic projection of the second light outlet Q2 on the substrate 101 may be smaller than an area of the orthographic projection of the second opening K2 on the substrate 101. In this way, it achieves limiting the exit angle of the first sub-pixel portion P21 (or the second sub-pixel portion P22, or the third sub-pixel portion P11, or the fourth sub-pixel portion P11), thereby facilitating the realization of the anti-peep effect.

In a possible implementation mode, an area of the orthographic projection of the first light outlet Q1 on the substrate 101 may be smaller than an area of the orthographic projection of the second light outlet Q2 on the substrate 101, which may enable the second sub-pixel portion P22 of the second display region AA2 to have limitation of the viewing angle in other directions (e.g., it can achieve emission of the second display region AA2 corresponding to the passenger seat having an angle in the direction of the windshield).

In a possible implementation mode, an area of the orthographic projection of the first light outlet Q1 on the substrate 101, and an area of the orthographic projection of the second light outlet Q2 on the substrate 101 may also be equal.

The number of light-shielding layers is not limited in the embodiments. In other examples, the number of light-shielding layers may be greater than or equal to three, and a protective layer may be provided between adjacent light-shielding layers.

FIG. 2A is an example of a partial cross-section of FIG. 1A along a direction A1A2. FIG. 2A illustrates a partial cross-sectional structure of a second sub-pixel P2. In some examples, as shown in FIG. 2A, in a direction perpendicular to the display panel, the display panel may include: a substrate 101; and a display structure layer, an encapsulation structure layer 104, a second shielding layer 107, a first protective layer 105 and a first shielding layer 106 which are sequentially disposed on the substrate 101. The display structure layer may include: a circuit structure layer 102 and a light-emitting structure layer 103 sequentially disposed on the substrate 101. In some possible implementations, the display panel may include other film layers, such as spacer pillars, etc., and the present disclosure is not limited herein. Herein, the circuit structure layer 102 may include: a buffer layer 210, a semiconductor layer 201, a first insulating layer 211, a first gate metal layer 204, a second insulating layer 212, a first source-drain metal layer 202 and a third insulating layer 213 disposed sequentially on the substrate 101.

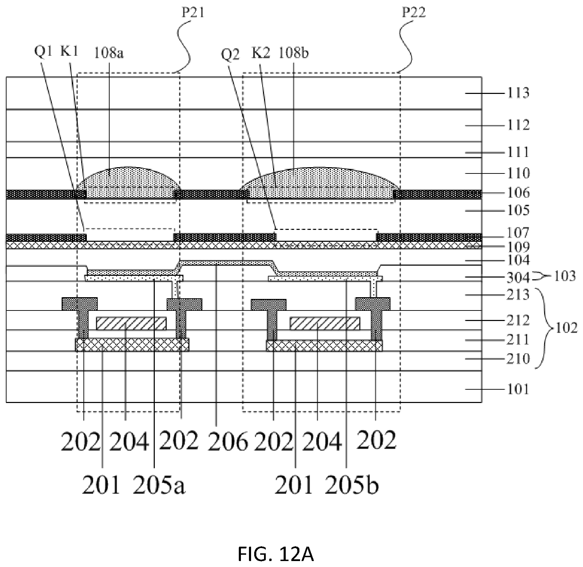

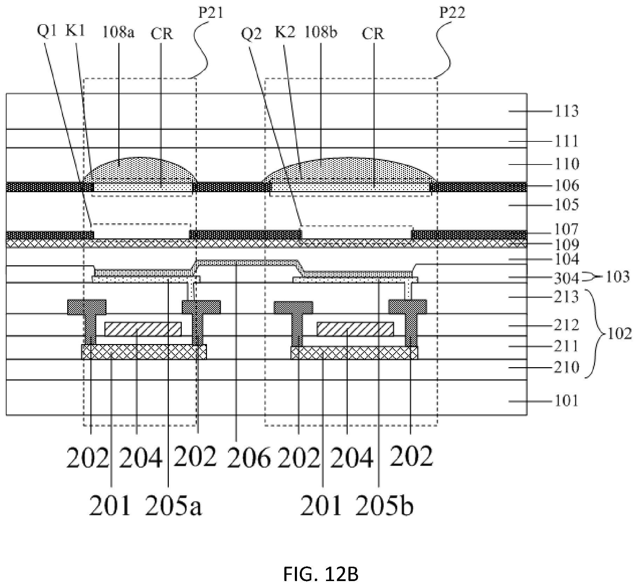

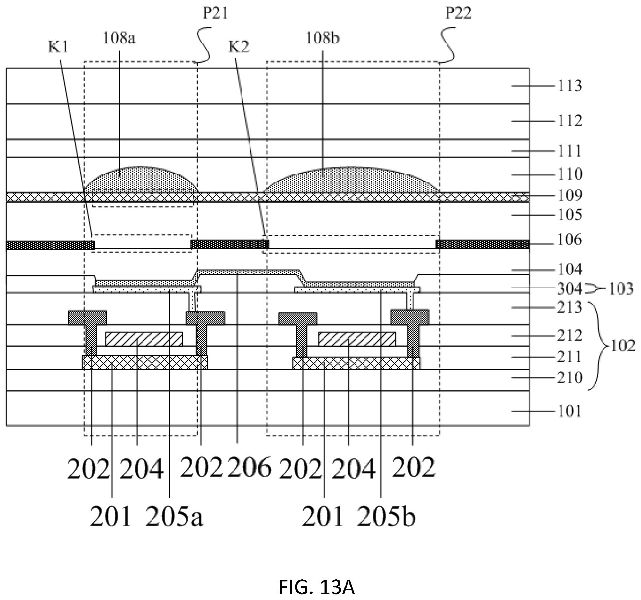

In a possible implementation mode, see FIG. 12A or FIG. 13A, the display panel further includes: a lens layer disposed on a side of the first light-shielding layer 106 facing away from the substrate 101; the lens layer may include: a first lens 108a and a second lens 108b; an orthographic projection of the first lens 108a on the substrate 101 covers an orthographic projection of the first opening K1 on the substrate 101; and an orthographic projection of the second lens 108b on the substrate 101 covers an orthographic projection of the second opening K2 on the substrate 101. In embodiments of the present disclosure, the display panel further includes: the first lens 108a and the second lens 108b; the orthographic projection of the first lens 108a on the substrate 101 covers the orthographic projection of the first opening K1 on the substrate 101; and the orthographic projection of the second lens 108b on the substrate 101 covers the orthographic projection of the second opening K2 on the substrate 101. Through the first lens 108a and the second lens 108b, it can realize the convergence of light rays from the corresponding light outlet, and improve the light-emitting brightness of the display panel.

In a possible implementation mode, as shown in FIG. 12A or FIG. 13A, the display panel further includes: an encapsulation layer 104, and a touch layer 109 disposed on a side of the encapsulation layer 104 facing away from the substrate; and the first light-shielding layer 106 is disposed on a side of the encapsulation layer 104 facing away from the substrate 101.

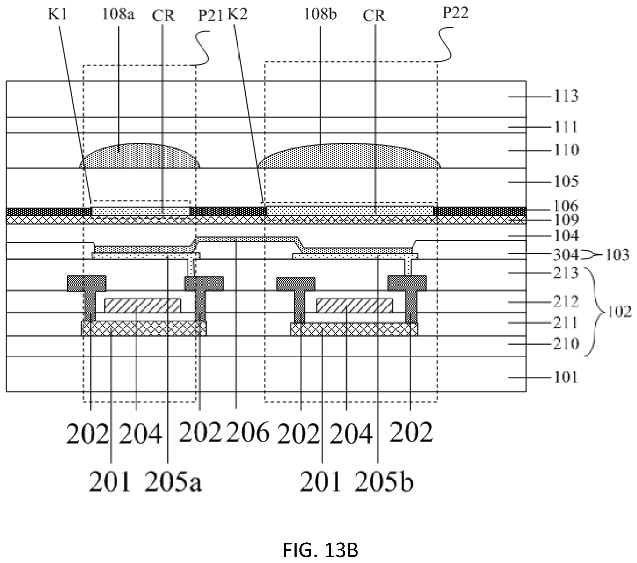

In a possible implementation mode, see FIG. 12A or FIG. 13B, the touch layer 109 may be disposed on a side of the first light-shielding layer 106 facing the substrate 101. Specifically, as shown in FIG. 12A, the touch layer 109 may be disposed on a side of the second light-shielding layer 107 facing the substrate 101, and specifically, the touch layer 109 may be a film layer in contact with the second light-shielding layer 107. Specifically, as shown in FIG. 13B, the touch layer 109 may also be a film layer in contact with the first light-shielding layer 106.

In another possible implementation mode, see FIG. 13A, the touch layer 109 may be disposed on a side of the first light-shielding layer 106 facing away from the substrate 101. Specifically, a first protective layer 105 may be disposed between the touch layer 109 and the first light-shielding layer 106. Specifically, the touch layer 109 may be a film layer in contact with the lens layer. Specifically, when the touch layer 109 is disposed on a side of the lens layer facing the substrate 101, the touch layer 109 may replace a light-shielding layer, for example, may replace the second light-shielding layer 107 shown in conjunction with FIGS. 12A and 13A.

In a possible implementation mode, shown in FIG. 12A, a second protective layer 110, an optical adhesive layer 111, a polarizer 112 and a cover plate 113 can also be sequentially disposed on a side of the lens layer facing away from the substrate 101.

In a possible implementation mode, the display panel in the embodiments of the present disclosure may be provided with a color film layer above the encapsulation layer 104, i.e., it may be a COE (CF On TFE). For example, as illustrated in FIG. 2A, FIG. 12B or FIG. 13B, the color film layer may include a first color resist CR (e.g., a red color resist) disposed at the first opening K1 and the second opening K2, and the color film layer may also include a second color resist (e.g., a green color resist that is not shown in FIG. 2A) and a third color resist (e.g., a blue color resist that is not shown in FIG. 2A). In a possible implementation mode, in embodiments of the present disclosure, the display panel may also be a non-COE structure, for example, shown in conjunction with FIG. 12A or FIG. 13A, the display panel may be provided with a polarizer 112.

In a possible implementation mode, the first light-shielding layer 106 and the second light-shielding layer 107 may be black matrix layers.

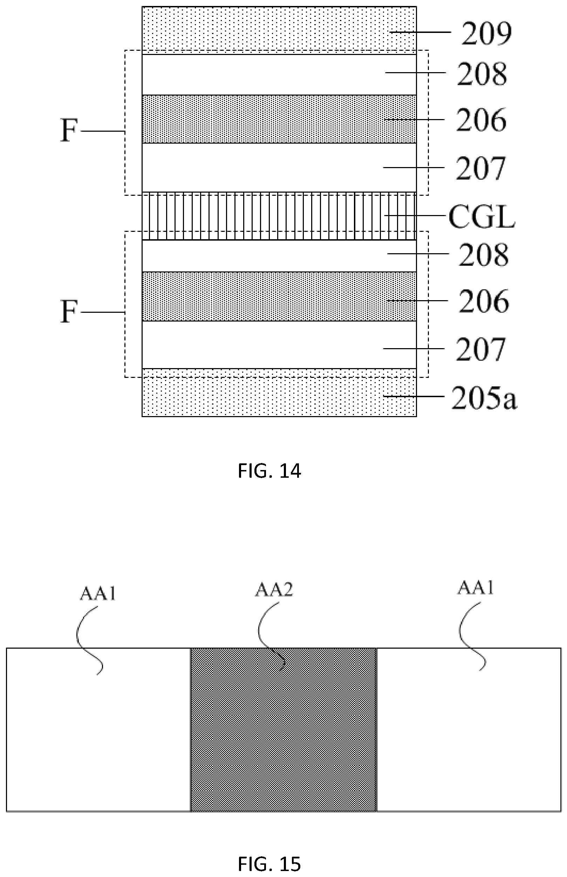

In a possible implementation mode, referring to FIG. 14, at least the second sub-pixels P2 among the first sub-pixels P1 and the second sub-pixels P2 include: a plurality of light emitters F disposed in a stacked manner along a direction perpendicular to the substrate 101; and the light emitters F include one or a combination of the following film layers disposed in a stacked manner: a hole transport layer 207, a light-emitting layer 206, or an electron transport layer 208.

In embodiments of the present disclosure, at least the second sub-pixels P2 include: a plurality of light emitters F disposed in a stacked manner along a direction perpendicular to the substrate 101, i.e., the second sub-pixel P2 is set as a stacked structure, which can enhance the brightness of the second sub-pixel P2, and improve the problem of the lower brightness and/or lifetime of the second sub-pixel P2 after the second sub-pixel P2 of the anti-peep display region is segmented.

In a possible implementation mode, see FIG. 14, a charge transport layer CGL may also be provided between two adjacent light emitters F.

In some exemplary embodiments, the display panel may be an organic light emitting diode (OLED) display panel, or may be a quantum dot light emitting diodes (QLED) display panel, or may be a plasma display panel (PDP), or may be an electrophoretic display (EPD) panel. It is not limited in the present embodiments.

In a possible implementation mode, the display panel may have only one first display region AA1 and one second display region AA2, and the first display region AA1 is located on a side of the second display region AA2, as shown in FIG. 1A. In another possible implementation mode, the display panel may also have more first display regions AA1, and more second display regions AA2. For example, as shown in FIG. 15, the display panel may have two first display regions AA1 and one second display region AA2, herein, the second display region AA2 is located between two first display regions AA1.

In a possible implementation mode, for the first display region AA1, the viewing angle in the direction perpendicular to the row direction of sub-pixels may also be narrowed for the first sub-pixel P1, for example, the width of the first light-shielding layer 106 in the column direction of sub-pixels may be narrowed, so that when the display panel is applied to the automotive field, the width of the first sub-pixel P1 in the column direction of sub-pixels (i.e., a direction perpendicular to the row direction of sub-pixels) may be narrowed when the row direction of sub-pixels is a direction pointing from the first display region AA1 to the second display region AA2, and the viewing angle in the direction of the first sub-pixel P1 emitting to the windshield can be narrowed to avoid that the image displayed in the first display region AA1 is reflected to the windshield, which may affect the normal vision of the main driver. For example, the position of the main driver may also have an anti-peep function, such as, it may also have a function of up and down anti-peep and left and right non-anti-peep.

FIG. 17 is a schematic diagram of a structure of a display panel according to at least one embodiment of the present disclosure. In some examples, as shown in FIG. 17, the display panel may include: a timing controller 20, a data driver 40, a gate drive circuit, and a sub-pixel array 10. The gate drive circuit may include at least one driver, for example, including a scanning driver 30. The timing controller 20, the data driver 40 and the gate drive circuit may be located in a peripheral region of a display region of the display panel. The sub-pixel array 10 in the display region may include a plurality of sub-pixels PX arranged regularly. The scanning driver 30 may be configured to provide a scan signal to the sub-pixel PX along a scan line; the data driver 40 may be configured to provide a data signal to the sub-pixel PX along a data line; and the timing controller 20 may be configured to control the scanning driver 30 and the data driver 40.

In some examples, the timing controller 20 may provide grayscale values and control signals suitable for the specifications of the data driver 40 to the data driver 40; and the timing controller 20 may provide a clock signal, an initial signal and the like suitable for the specifications of the scanning driver 30 to the scanning driver 30. The data driver 40 may utilize the grayscale values and the control signals received from the timing controller 20 to generate data voltages that will be provided to the data lines D1 to Dn. For example, the data driver 40 may sample the grayscale values using the clock signal and apply data signals corresponding to the grayscale values to the data lines D1 to Dn in a unit of a sub-pixel row. The scanning driver 30 may generate the scan signal that will be supplied to the scan lines G1 to Gm by using the clock signal, the initial signal and the like received from the timing controller 20. For example, the scanning driver 30 may sequentially provide the scan signal having conducted level pulses to the scan lines. In some examples, the scanning driver 30 may include a shift register that may generate the scan signal in a manner that the scanning initial signal provided in the form of conducted level pulses is sequentially transmitted to the next stage of circuit under the control of a clock signal. Herein, n and m are natural numbers.

In some examples, the gate driver circuit may be disposed directly on the substrate. For example, the gate drivers may be disposed in a peripheral region on the left and right sides of the display region. In some examples, the gate driver may be formed with the sub-pixels in a process for forming the sub-pixels. However, the present embodiments do not limit the position or formation method of the gate drivers. In some examples, the gate drivers may be provided on a separate chip or a printed circuit board to be attached to pads or solder pads formed on the substrate.

In some examples, the data driver 40 may be provided on a separate chip or a printed circuit board to be connected to the sub-pixels PX via signal access pins provided on the substrate. For example, the data driver 40 may be provided using a chip-on-glass, chip-on-plastic, chip-on-film or the like to be connected to signal access pins on the substrate. The timing controller 20 may be provided separately from the data driver 40 or integrally provided with the data driver 40. However, the present embodiments do not limit to this.

Based on the same inventive conception, embodiments of the present disclosure also provide a display apparatus, including the display panel according to embodiments of the present disclosure.

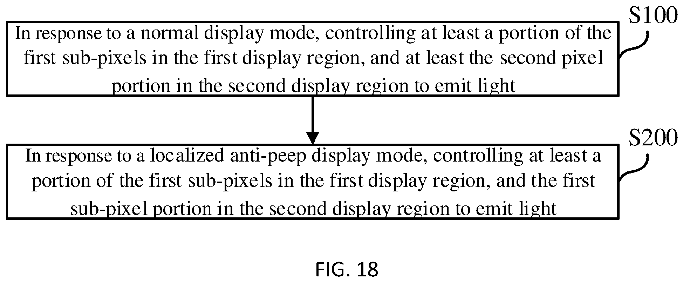

Based on the same inventive conception, embodiments of the present disclosure further provide a driving method of the display panel according to the embodiments of the present disclosure, see FIG. 18, including: step S100, in response to a normal display mode, controlling at least a portion of the first sub-pixels in the first display region, and at least the second pixel portion in the second display region to emit light; and step S200, in response to a localized anti-peep display mode, controlling at least a portion of the first sub-pixels in the first display region, and the first pixel portion in the second display region to emit light.

In a possible implementation mode, with respect to the display panel corresponding to FIG. 1A, that is, when segmenting the second sub-pixel P2 in the second display region AA2 into the first pixel portion P21 in an anti-peep mode and the second pixel portion P22 displayed normally, and when segmenting the first sub-pixel P1 in the first display region AA1 into the third pixel portion P11 and the fourth pixel portion P12 that are both displayed normally, in a case of different display modes, the step S100 of controlling the first sub-pixels in the first display region and at least the second pixel portion in the second display region to emit light in response to the normal display mode, includes: controlling the fourth pixel portion P12 in the first display region AA1 and the second pixel portion P22 in the second display region AA2 to emit light in response to the normal display mode, as shown in FIG. 1C.

The step 2100 of controlling at least a portion of the first sub-pixels in the first display region and the first sub-pixel portion in the second display region to emit light in response to the localized anti-peep display mode, includes: controlling the third pixel portion P11 in the first display region AA1 and the first pixel portion P21 in the second display region AA2 to emit light, as shown in FIG. 1B.

In a possible implementation mode, with respect to the display panel corresponding to FIG. 5A, that is, when segmenting the second sub-pixel P2 in the second display region AA2 into the first pixel portion P21 in an anti-peep mode and the second pixel portion P22 displayed normally, and when segmenting the first sub-pixel P1 in the first display region AA1 into the third pixel portion P11 in an anti-peep mode and the fourth pixel portion P12 displayed normally, in a case of different display modes, the step S100 of controlling the first sub-pixels in the first display region and at least the second pixel portion in the second display region to emit light in response to the normal display mode, includes: controlling all of the plurality of first sub-pixels P1 in the first display region AA1 and all of the plurality of second sub-pixels P2 in the second display region AA2 to emit light in response to the normal display mode, as illustrated in FIG. 5C.

The step S200 of controlling at least a portion of the first sub-pixels in the first display region and the first sub-pixel portion in the second display region to emit light in response to the localized anti-peep display mode, includes: controlling all of the plurality of first sub-pixels P1 in the first display region AA1 and the first pixel portion P21 in the second display region AA2 to emit light, as illustrated in FIG. 5B.

In a possible implementation mode, with respect to the display panel corresponding to FIG. 9A, that, when the second sub-pixel P2 in the second display region AA2 is segmented into the first pixel portion P21 in an anti-peep mode and the second pixel portion P22 displayed normally, and when the first sub-pixel P1 in the first display region AA1 is not segmented, in a case of different display modes, the step S100 of controlling the first sub-pixels in the first display region and at least the second pixel portion in the second display region to emit light in response to the normal display mode, includes: controlling all of the plurality of first sub-pixels P1 in the first display region AA1 and the second pixel portion P22 in the second display region AA2 to emit light in response to the normal display mode, as shown in FIG. 9C.

The step S200 of controlling at least a portion of the first sub-pixels in the first display region and the first sub-pixel portion in the second display region to emit light in response to the localized anti-peep display mode, includes: controlling all of the plurality of first sub-pixels P1 in the first display region AA1 and the first pixel portion P21 in the second display region AA2 to emit light, as illustrated in FIG. 9B.

In a possible implementation mode, the driving method in the embodiments of the present disclosure further includes: a step S300, in response to the normal display mode, based on a difference in brightness between the first display region and the second display region, calling a stored relationship table, and adjusting the brightness of the first display region and the second display region to be consistent. The relationship table includes: a gamma correction relationship table (Gama Look-Up Table, Gama LUT), and/or a moiré correction relationship table (Demura LUT), and/or a luminance decay relationship table (De Burn-in LUT).

Specifically, for the display panel structure corresponding to FIG. 1A, i.e., when the second sub-pixel P2 in the second display region AA2 is segmented into a first pixel portion P21 in an anti-peep mode and a second pixel portion P22 displayed normally, and when the first sub-pixel P1 in the first display region AA1 is segmented into a third pixel portion P11 and a fourth pixel portion P12 that are both displayed normally, a first Gama LUT, a second Gama LUT and a third Gama LUT are correspondingly stored in the display apparatus. Herein, the first Gama LUT, which corresponds to the first display region AA1, is used for correcting the brightness of the first display region AA1 in the anti-peep display mode; the second Gama LUT, which corresponds to the second display region AA2, is used for correcting the brightness of the second display region AA2 in the anti-peep display mode; and the third Gama LUT, which corresponds to the first display region AA1 and the second display region AA2, is used for correcting the brightness of the first display region AA1 and the second display region AA2 in the normal display (i.e., shared display) mode. Furthermore, a first Demura LUT and a second Demura LUT may also be stored in the display apparatus. Herein, the first Demura LUT corresponds to the first display region AA1 and the second display region AA2, and is used for correcting the brightness of the first display region AA1 and the second display region AA2 in a case of the anti-peep display; and the second Demura LUT corresponds to the first display region AA1 and the second display region AA2, and is used for correcting the brightness of the first display region AA1 and the second display region AA2 in a case of the shared display. Furthermore, a first De Burn-in LUT, a second De Burn-in LUT and a third De Burn-in LUT can also be stored in the display apparatus. Herein, the first De Burn-in LUT corresponds to the first display region AA1, and is used for correcting the brightness of the first display region AA1 in the anti-peep display mode; the second De Burn-in LUT corresponds to the second display region AA2, and is used for correcting the brightness of the second display region AA2 in the anti-peep display mode; and the third De Burn-in LUT corresponds to the first display region AA1 and the second display region AA2, and is used for correcting the brightness of the first display region AA1 and the second display region AA2 in the shared display mode.

Specifically, for the display panel structure corresponding to FIG. 1A, i.e., when segmenting the second sub-pixel P2 in the second display region AA2 into a first pixel portion P21 in an anti-peep mode and a second pixel portion P22 displayed normally, and when segmenting the first sub-pixel P1 in the first display region AA1 into a third pixel portion P11 and a fourth pixel portion P12 that are both displayed normally, a first Gama LUT and a second Gama LUT may be stored in the display apparatus. Herein, the first Gama LUT corresponds to the second display region AA2, and is used for correcting the brightness of the second display region AA2 in a case of the anti-peep display; and the second Gama LUT corresponds to the first display region AA1 and the second display region AA2, and is used for correcting the brightness of the first display region AA1 in a case of the anti-peep display and for correcting the brightness of the first display region AA1 and the second display region AA2 in a case of the shared display. Furthermore, a first Demura LUT and a second Demura LUT may be stored in the display apparatus. Herein, the first Demura LUT corresponds to the first display region AA1 and the second display region AA2, and is used for correcting the brightness of the first display region AA1 and the second display region AA2 in a case of the anti-peep display; and the second Demura LUT corresponds to the first display region AA1 and the second display region AA2, and is used for correcting the brightness of the first display region AA1 and the second display region AA2 in a case of the shared display. Furthermore, a first De Burn-in LUT, a second De Burn-in LUT and a third De Burn-in LUT may be stored in the display apparatus. Herein, the first De Burn-in LUT corresponds to the first display region AA1, and is used for correcting the brightness of the first display region AA1 in a case of the anti-peep display; the second De Burn-in LUT corresponds to the second display region AA2, and is used for correcting the brightness of the second display region AA2 in a case of the anti-peep display and the shared display; and the third De Burn-in LUT corresponds to the second display region AA2, and is used for correcting the brightness of the second display region AA2 in a case of the shared display.

Specifically, for the display panel structure corresponding to FIG. 9A, i.e., when the second sub-pixel P2 in the second display region AA2 is segmented into a first pixel portion P21 in an anti-peep mode and a second pixel portion P22 displayed normally, and when the first sub-pixel P1 in the first display region AA1 is not segmented, a first Gama LUT, a second Gama LUT and a third Gama LUT may be correspondingly stored in the display apparatus. Herein, the first Gama LUT, which corresponds to the first display region AA1, is used for correcting the brightness of the first display region AA1 in the anti-peep display mode and the shared display mode; the second Gama LUT, which corresponds to the second display region AA2, is used for correcting the brightness of the second display region AA2 in the anti-peep mode; and the third Gama LUT, which corresponds to the second display region AA2, is used for correcting the brightness of the second display region AA2 in the shared display mode. Furthermore, a first Demura LUT and a second Demura LUT may also be stored in the display apparatus. Herein, the first Demura LUT corresponds to the first display region AA1 and the second display region AA2, and is used for correcting the brightness of the first display region AA1 and the second display region AA2 in a case of the anti-peep display AA2; and the second Demura LUT corresponds to the first display region AA1 and the second display region AA2, and is used for correcting the brightness of the first display region AA1 and the second display region AA2 in a case of the shared display. Furthermore, a first De Burn-in LUT, a second De Burn-in LUT and a third De Burn-in LUT may also be stored in the display apparatus. Herein, the first De Burn-in LUT corresponds to the first display region AA1, and is used for correcting the brightness of the first display region AA1 in the anti-peep display mode and the shared display mode; the second De Burn-in LUT corresponds to the second display region AA2, and is used for correcting the brightness of the second display region AA2 in the anti-peep display mode; and the third De Burn-in LUT corresponds to the second display region AA2, and is used for correcting the brightness of the second display region AA2 in the shared display mode.

Although preferred embodiments of the present disclosure have been described, these embodiments may be additionally changed and modified by those skilled in the art once the basic inventive concepts are known. Therefore, the appended claims are intended to be construed to include the preferred embodiments and all changes and modifications that fall within the scope of the present disclosure.

Obviously, those skilled in the art may make various changes and variations to the embodiments of the present disclosure without departing from the spirit and scope of the embodiments of the present disclosure. Thus, if such modifications and variations of the embodiments of the present disclosure fall within the scope of the claims of the present disclosure and their technical equivalents, the present disclosure is intended to encompass such modifications and variations.

## Claims

1. A display panel, comprising:
a substrate, having a first display region and a second display region;
a plurality of first sub-pixels in the first display region; and
a plurality of second sub-pixels in the second display region; wherein at least one of the plurality of second sub-pixels comprises: a first pixel portion and a second pixel portion; wherein a light-emitting area of the first pixel portion is smaller than a light-emitting area of the second pixel portion.

2. The display panel according to claim 1, wherein at least one of the plurality of first sub-pixels comprises: a third pixel portion and a fourth pixel portion; and a light-emitting area of the third pixel portion is equal to a light-emitting area of the fourth pixel portion.

3. The display panel according to claim 1, wherein at least one of the plurality of first sub-pixels comprises: a third pixel portion and a fourth pixel portion; and a light-emitting area of the third pixel portion is smaller than a light-emitting area of the fourth pixel portion.

4. The display panel according to claim 2 or 3, wherein the light-emitting area of the fourth pixel portion is equal to the light-emitting area of the second pixel portion.

5. The display panel according to claim 1, wherein at least one of the plurality of first sub-pixels is of an one-piece connection structure.

6. The display panel according to claim 5, wherein a light-emitting area of the first sub-pixel is greater than or equal to a sum of the light-emitting area of the first pixel portion and the light-emitting area of the second pixel portion.

7. The display panel according to any one of claims 1-6, comprising: a first shielding layer;
wherein the first shielding layer comprises: a first opening and a second opening;
an orthographic projection of the first opening on the substrate has an overlapping region with an orthographic projection of the first pixel portion on the substrate;
an orthographic projection of the second opening on the substrate has an overlapping region with an orthographic projection of the second pixel portion on the substrate;
an area of the orthographic projection of the first opening on the substrate is less than an area of the orthographic projection of the second opening on the substrate.

8. The display panel according to claim 7, wherein at least one of the plurality of first sub-pixels comprises: a third pixel portion and a fourth pixel portion;
the first shielding layer further comprises: a third opening and a fourth opening;
an orthographic projection of the third opening on the substrate has an overlapping region with an orthographic projection of the third pixel portion on the substrate;
an orthographic projection of the fourth opening on the substrate has an overlapping region with an orthographic projection of the fourth pixel portion on the substrate;
an area of the orthographic projection of the fourth opening on the substrate is equal to the area of the orthographic projection of the second opening on the substrate.

9. The display panel according to claim 8, wherein an area of the orthographic projection of the third opening on the substrate is equal to the area of the orthographic projection of the fourth opening on the substrate.

10. The display panel according to claim 8, wherein an area of the orthographic projection of the third opening on the substrate is less than the area of the orthographic projection of the fourth opening on the substrate.

11. The display panel according to claim 7, wherein at least one of the plurality of first sub-pixels is of an one-piece connection structure;
the first shielding layer further comprises: a fifth opening; and
an orthographic projection of the fifth opening on the substrate has an overlapping region with an orthographic projection of the first sub-pixel on the substrate.

12. The display panel according to claim 11, wherein an area of the orthographic projection of the fifth opening on the substrate is greater than or equal to a sum of the area of the orthographic projection of the first opening on the substrate and the area of the orthographic projection of the second opening on the substrate.

13. The display panel according to any one of claims 7-12, wherein the first opening comprises: a plurality of first sub-openings; and the plurality of first sub-openings of the first opening are distributed in an array.

14. The display panel according to claim 13, wherein an orthographic projection of the first sub-opening on the substrate has a rectangular, hexagonal, octagonal, circular, or elliptical pattern.

15. The display panel according to any one of claims 1-14, wherein the first pixel portion comprises: a first anode portion; and the second pixel portion comprises: a second anode portion;
an area of an orthographic projection of the first anode portion on the substrate is smaller than an area of an orthographic projection of the second anode portion on the substrate.

16. The display panel according to claim 15, wherein at least one of the plurality of first sub-pixels comprises: a third pixel portion and a fourth pixel portion;
the third pixel portion comprises a third anode portion, and the fourth pixel portion comprises a fourth anode portion; and
an area of an orthographic projection of the third anode portion on the substrate is equal to an area of an orthographic projection of the fourth anode portion on the substrate.

17. The display panel according to claim 16, wherein at least one of the plurality of first sub-pixels is of an one-piece connection structure;
the first sub-pixel portion comprises: a fifth anode portion;
an area of an orthographic projection of the fifth anode portion on the substrate is greater than or equal to a sum of the area of the orthographic projection of the first anode portion on the substrate and the area of the orthographic projection of the second anode portion on the substrate.

18. The display panel according to any one of claims 7-17, further comprising: a second light-shielding layer on a side of the first light-shielding layer facing the substrate;
wherein the second light-shielding layer comprises: a first light outlet and a second light outlet;
an orthographic projection of the first light outlet on the substrate has an overlapping region with the orthographic projection of the first opening on the substrate; and
an orthographic projection of the second light outlet on the substrate has an overlapping region with the orthographic projection of the second opening on the substrate.

19. The display panel according to any one of claims 7-18, further comprising: a lens layer on a side of the first light-shielding layer facing away from the substrate;
wherein the lens layer comprises: a first lens and a second lens;
an orthographic projection of the first lens on the substrate covers the orthographic projection of the first opening on the substrate; and
an orthographic projection of the second lens on the substrate covers the orthographic projection of the second opening on the substrate.

20. The display panel according to any one of claims 7-19, further comprising: an encapsulation layer, and a touch layer on a side of the encapsulation layer facing away from the substrate;
wherein the first light-shielding layer is on a side of the encapsulation layer facing away from the substrate.

21. The display panel according to any one of claims 1-20, wherein at least the second sub-pixels among the first sub-pixels and the second sub-pixels comprise: a plurality of light emitters disposed in a stacked manner along a direction perpendicular to the substrate;
the light emitters comprise one or a combination of following film layers disposed in a stacked manner:
a hole transport layer;
a light-emitting layer; or
an electron transport layer.

22. The display panel according to any one of claims 15-21, wherein the second sub-pixel comprises: a second pixel circuit; and
the first anode portion and the second anode portion are both electrically connected to the second pixel circuit.

23. The display panel according to claim 22, wherein the second pixel circuit comprises at least a first light-emitting control sub-circuit and a second light-emitting control sub-circuit;
the display panel further comprises: a first light-emitting control line and a second light-emitting control line;
the first light-emitting control sub-circuit is electrically connected to the first light-emitting control line and the first anode portion, and is configured to drive the first pixel portion to emit light under control of the first light-emitting control line;
the second light-emitting control sub-circuit is electrically connected to the second light-emitting control line and the second anode portion, and is configured to drive the second pixel portion to emit light under control of the second light-emitting control line.

24. The display panel according to any one of claims 15-21, wherein the second sub-pixel comprises: a first sub-pixel circuit and a second sub-pixel circuit;
the first anode portion is electrically connected to the first sub-pixel circuit; and
the second anode portion is electrically connected to the second sub-pixel circuit.

25. The display panel according to claim 24, wherein the plurality of second sub-pixels comprise: first pixel rows and second pixel rows; the first pixel rows and the second pixel rows extend in a first direction and are alternately arranged in a second direction; the first pixel row comprises: a plurality of first pixel portions; and the second pixel row comprises: a plurality of second pixel portions;
the display panel further comprises: a first pixel row control line and a second pixel row control line; the first pixel row control line is electrically connected to the first pixel portions of the first pixel row, and the second pixel row control line is electrically connected to the second pixel portions of the second pixel row; and the first pixel row control line is configured to provide a signal to the first pixel portions of the first pixel row, and the second pixel row control line is configured to provide a signal to the second pixel portions of the second pixel row.

26. A display apparatus, comprising the display panel according to any one of claims 1-25.

27. A driving method for the display panel according to any one of claims 1-25, comprising:
in response to a normal display mode, controlling at least a portion of the plurality of first sub-pixels in the first display region and at least the second pixel portion in the second display region to emit light; and
in response to a localized anti-peek display mode, controlling at least a portion of the plurality of first sub-pixels in the first display region and the first pixel portion in the second display region to emit light.

28. The driving method according to claim 27, wherein:
in response to the normal display mode, controlling at least a portion of the plurality of first sub-pixels in the first display region and at least the second pixel portion in the second display region to emit light, comprises:
in response to the normal display mode, controlling the fourth pixel portion in the first display region and the second pixel portion in the second display region to emit light;
in response to the localized anti-peek display mode, controlling at least a portion of the plurality of first sub-pixels in the first display region and the first sub-pixel portion in the second display region to emit light, comprises:
controlling the third pixel portion in the first display region and the first pixel portion in the second display region to emit light.

29. The driving method according to claim 27, wherein:
in response to the normal display mode, controlling at least a portion of the plurality of first sub-pixels in the first display region and at least the second pixel portion in the second display region to emit light, comprises:
in response to the normal display mode, controlling all of the plurality of first sub-pixels in the first display region and all of the plurality of second sub-pixels in the second display region to emit light;
in response to the localized anti-peek display mode, controlling at least a portion of the plurality of first sub-pixels in the first display region and the first sub-pixel portion in the second display region to emit light, comprises:
controlling all of the plurality of first sub-pixels in the first display region and the first pixel portion in the second display region to emit light.

30. The driving method according to claim 29, wherein:
in response to the normal display mode, controlling at least a portion of the plurality of first sub-pixels in the first display region and at least the second pixel portion in the second display region to emit light, comprises:
in response to the normal display mode, controlling all of the plurality of first sub-pixels in the first display region and the second pixel portion in the second display region to emit light;
in response to the localized anti-peek display mode, controlling at least a portion of the plurality of first sub-pixels in the first display region and the first pixel portion in the second display region to emit light, comprises:
controlling all of the plurality of first sub-pixels in the first display region and the first pixel portion in the second display region to emit light.

31. The driving method according to any one of claims 27-30, further comprising:
in response to the normal display mode, based on a difference in brightness between the first display region and the second display region, calling a stored relationship table, and adjusting the brightness of the first display region and the second display region.
